# EUROPEAN PATENT APPLICATION

(11) **EP 4 576 947 A1**
(43) Date of publication of application: **25.06.2025**
(21) Application number: 23855194.9
(22) Date of filing: 18.08.2023
(51) Int. Cl.: H05K 1/03, H05K 3/28, H05K 1/11, H05K 1/18, H01L 23/13, H01L 23/498, H01L 23/00, H01L 23/538

(54) **CIRCUIT BOARD AND SEMICONDUCTOR PACKAGE COMPRISING SAME**

(30) Priority: 18.08.2022 KR 20220103156; 23.08.2022 KR 20220105212
(71) Applicant: LG INNOTEK CO. LTD, Gangseo-gu Seoul 07796 (KR)
(72) Inventor: LEE, Dong Keon, Seoul 07796 (KR); SHIN, Jun Sik, Seoul 07796 (KR); YUN, Nam Gyu, Seoul 07796 (KR); CHOI, So Hee, Seoul 07796 (KR)
(74) Representative: Plasseraud IP
(86) International application number: PCT/KR2023/012290
(87) International publication number: WO 2024/039228

(57) **Abstract**

A circuit board according to an embodiment includes a first insulating layer; a second insulating layer disposed on the first insulating layer; and a circuit pattern layer disposed between the first insulating layer and the second insulating layer, wherein the second insulating layer includes a cavity passing through upper and lower surfaces of the second insulating layer, and wherein the circuit pattern layer includes: an electrode pad disposed on a lower surface of the cavity; and a dummy electrode disposed on the lower surface of the cavity and spaced apart from the electrode pad and surrounding an outer side of the electrode pad.

## Description

### [Technical Field]

An embodiment relates to a circuit board and a semiconductor package including the same.

### [Background Art]

As the performance of electric/electronic products is being improved, technologies for attaching a larger number of packages to a limited-sized circuit board are being proposed and studied.

A typical semiconductor package has a structure in which multiple chips are disposed. In addition, recently, a size of the semiconductor package is increasing due to the high-specification of products to which semiconductor packages are applied and the adoption of multiple chips such as HBM (High Bandwidth Memory). Accordingly, the semiconductor package includes an interposer to connect multiple chips.

In addition, semiconductor packages applied to products that provide the Internet of Things (IoT), autonomous vehicles, and high-performance servers require high performance and high reliability in accordance with a trend of high integration.

Furthermore, the semiconductor package has a vertical connection structure between multiple circuit boards, interposers, and semiconductor devices. Accordingly, a thickness of the semiconductor package in a vertical direction can increase depending on a thickness and a number of the circuit board, interposer, and semiconductor devices.

Therefore, the semiconductor package is reducing the thickness in the vertical direction by using a circuit board with a cavity.

At this time, a de-smear process must be performed in a process of manufacturing a circuit board including a cavity. That is, if the de-smear process is not performed, an adhesion between a molding member disposed in the cavity and the circuit board decreases, and as a result, the molding member is separated from the circuit board.

In addition, if the de-smear process is performed, a lower surface of the cavity may be etched together with a side wall of the cavity. As a result, damage may occur to the lower surface of the cavity, which may cause problems with physical reliability of the circuit board.

In addition, the lower surface of the cavity may be an upper surface of a thermosetting resin including glass fibers. As the de-smear process is performed, the thermosetting resin is etched, and as a result, the glass fibers provided in the thermosetting resin may be exposed through the cavity. In addition, the exposed glass fibers may act as a factor causing defects such as copper migration.

(Patent Document 1) KR 10-2012-0045639 A

### [Disclosure]

### [Technical Problem]

The embodiment provides a circuit board having a novel structure and a semiconductor package including the same.

In addition, the embodiment provides a circuit board including a cavity and a semiconductor package including the same.

In addition, the embodiment provides a circuit board capable of improving circuit integration and a semiconductor package including the same.

In addition, the embodiment provides a circuit board capable of solving a reliability problem that occurs due to glass fibers provided in an insulating layer being exposed through a cavity and a semiconductor package including the same.

In addition, the embodiment provides a circuit board capable of improving adhesion between a plurality of insulating layers including different insulating materials and a semiconductor package including the same.

In addition, the embodiment provides a circuit board with improved warpage characteristics and a semiconductor package including the same.

In addition, the embodiment provides a circuit board capable of preventing foreign substances from occurring on a side surface and a semiconductor package including the same.

In addition, the embodiment provides a circuit board capable of improving heat dissipation characteristics and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises a first insulating layer; a second insulating layer disposed on the first insulating layer; and a circuit pattern layer disposed between the first insulating layer and the second insulating layer, wherein the second insulating layer includes a cavity passing through upper and lower surfaces of the second insulating layer, and wherein the circuit pattern layer includes: an electrode pad disposed on a lower surface of the cavity; and a dummy electrode disposed on the lower surface of the cavity and spaced apart from the electrode pad and surrounding an outer side of the electrode pad.

In addition, an outer side surface of the first insulating layer has a step with respect to an outer side surface of the second insulating layer.

In addition, the first insulating layer and the second insulating layer include different insulating materials.

In addition, the second insulating layer includes a photocurable resin.

In addition, the outer side surface of the second insulating layer is provided further inward than the outer side surface of the first insulating layer.

In addition, the circuit board further comprises a protective layer disposed on the second insulating layer, and wherein an outer side surface of the protective layer has a step with respect to the outer side surface of the second insulating layer.

In addition, the protective layer is provided to cover the outer side surface of the second insulating layer.

In addition, the outer side surface of the second insulating layer has a slope in which an outer width of the second insulating layer decreases or increases from the upper surface of the second insulating layer toward the lower surface of the second insulating layer.

In addition, the protective layer includes an opening overlapping the cavity in a vertical direction, and a slope of an inner wall of the opening is different from a slope of an inner wall of the cavity.

In addition, a direction in which the slope of the inner wall of the opening is inclined is different from a direction in which the slope of the inner wall of the cavity is inclined.

In addition, the slope of the inner wall of the cavity of the second insulating layer includes a first portion connected to the lower surface of the second insulating layer and having a straight slope in which a width of the cavity narrows toward the upper surface of the second insulating layer, and a second portion provided between the upper surface of the second insulating layer and the first portion and having a curved slope in which a width of the cavity increases toward the lower surface of the second insulating layer.

In addition, the circuit board further comprises a first through electrode passing through the first insulating layer; and a second through electrode overlapping the cavity in a horizontal direction and passing through the second insulating layer, and a vertical thickness of the second through electrode is smaller than a thickness of the electrode pad in a vertical direction and a thickness of the first through electrode.

In addition, the second insulating layer is provided in a plurality of layers, and the cavity passes through at least one layer among the plurality of layers of the second insulating layer.

In addition, the second insulating layer includes a first layer disposed on the first insulating layer and a second layer disposed on the first layer, and the second through electrode includes a first through part passing through the first layer and a second through part passing through the second layer, and the first through part and the second through part are in direct contact with each other.

In addition, the first through part has a slope whose width decreases from an upper surface of the first through part toward the lower surface of the first through part, and the second through part has a slope whose width decreases from an upper surface of the second through part toward a lower surface of the second through part, and a center of the first through part in a horizontal direction is misaligned with a center of the second through part in a horizontal direction.

In addition, the circuit pattern layer further includes a pad part that does not vertically overlap with the cavity, and a connection pattern connecting the pad part and the electrode pad, and the dummy electrode is provided to surround the outer side of the electrode pad at a position spaced from the electrode pad and the connection pattern.

In addition, the circuit board further comprises a connection member disposed in the cavity and disposed on the electrode pad.

In addition, the first through electrode is provided in a plurality, and at least one of the plurality of first through electrodes overlaps the dummy electrode in a vertical direction.

Meanwhile, the semiconductor package according to the embodiment includes any one of the circuit boards described above and a semiconductor device disposed on the circuit board.

In addition, the semiconductor device is disposed in a plurality on the circuit board along at least one of the vertical direction and the horizontal direction.

### [Advantageous Effects]

The circuit board according to the embodiment may include a first insulating layer and a second insulating layer disposed on the first insulating layer. At this time, the first insulating layer may include a first insulating material, and the second insulating layer may include a second insulating material different from the first insulating material. In addition, an outer side surface of the first insulating layer may have a step with an outer side surface of the second insulating layer. Accordingly, the embodiment may improve the adhesion between the first insulating layer and the second insulating layer, while preventing the circuit board from being bent in a specific direction.

For example, the first insulating layer may include a thermosetting resin, and the second insulating layer may include a photocurable resin. As a result, the adhesion between the first insulating layer and the second insulating layer may be reduced. Furthermore, the first insulating layer and the second insulating layer may have different thermal expansion coefficients. Therefore, a problem may occur in which the circuit board is significantly bent in a specific direction due to a difference in the thermal expansion coefficients between the first insulating layer and the second insulating layer. At this time, a bending of the circuit board may be caused by the second insulating layer including the photocurable resin.

Therefore, the embodiment can allow an outer width of the second insulating layer to be smaller than the outer width of the first insulating layer. Therefore, the embodiment can prevent the circuit board from being bent in a specific direction by the second insulating layer. Through this, the embodiment can improve physical reliability and electrical reliability of the circuit board.

Furthermore, the embodiment may allow the first protective layer to be disposed on the second insulating layer so as to surround the upper surface and outer side surface of the second insulating layer. The first protective layer can have a function of protecting the circuit pattern layer disposed on the second insulating layer while improving the adhesion between the first insulating layer and the second insulating layer. Accordingly, the embodiment can improve the adhesion between the first insulating layer and the second insulating layer. Accordingly, the embodiment can solve a problem of the second insulating layer being peeled off from the first insulating layer or the physical reliability problem of the circuit pattern layer disposed on the second insulating layer being peeled off from the second insulating layer.

In addition, the circuit board of the embodiment may include a third insulating layer disposed under the first insulating layer. The third insulating layer may be disposed under the first insulating layer while having an insulating material corresponding to the second insulating layer and a structure corresponding to the second insulating layer. For example, a structure of the third insulating layer may have a symmetrical structure with respect to a structure of the second insulating layer based on the first insulating layer. Accordingly, the embodiment may solve a warpage problem of the circuit board caused by an asymmetrical structure, thereby improving the electrical reliability and/or physical reliability of the circuit board and the semiconductor package including the same.

Meanwhile, an outer side surface of the circuit board of the embodiment does not include a portion corresponding to the second insulating layer and/or the third insulating layer. For example, the outer side surface of the second insulating layer and/or the third insulating layer may be covered by the first protective layer and the second protective layer. Through this, the outer side surface of the second insulating layer and/or the third insulating layer may not be exposed to an outside of the circuit board. Accordingly, the embodiment may solve a damage problem caused by exposure of an outer side surface of a second insulating layer and/or a third insulating layer having relatively weak rigidity to an outside of the circuit board. Furthermore, the embodiment may solve a generation of foreign substances by the second insulating layer and/or the third insulating layer in a sawing process in which a circuit board is manufactured by a strip unit. Accordingly, the embodiment may improve overall product reliability of the circuit board and the semiconductor package.

In addition, the circuit board of the embodiment can include a first circuit pattern layer disposed on the first insulating layer. In addition, the second insulating layer can include a cavity. In addition, the first circuit pattern layer includes a first circuit pattern part disposed on a first region of the first insulating layer that vertically overlaps the cavity. At this time, a plane area occupied by the first circuit pattern portion in the first region can satisfy a range of 50% to 90% of a total plane area of the first region. That is, a plane area of a part where the first circuit pattern part is not disposed in the first region of the first insulating layer can satisfy a range of 10% to 50% of the total plane area of the first region. Through this, the embodiment can prevent an upper surface of the first region of the first insulating layer from being damaged in a de-smear process after the cavity is formed. Through this, the embodiment can prevent reliability problems such as copper migration caused by etching of the first region of the first insulating layer in the de-smear process. Therefore, the embodiment can improve the electrical reliability of the circuit board and the semiconductor package including the same. In addition, the embodiment can allow a thickness of the through electrode overlapping the cavity in the horizontal direction to be smaller than the thickness of the electrode pad of the first circuit pattern layer.

Furthermore, the thickness of the through electrode overlapping the cavity in the horizontal direction and passing through the second insulating layer can be reduced to 1/1.5, further 1/2, further 1/3, and further 1/3.5 of the thickness of the through electrode passing through the first insulating layer. Through this, the embodiment can reduce a signal transmission distance and minimize the signal transmission loss accordingly.

In addition, the embodiment can provide a through electrode in which a second insulating layer is provided with a plurality of layers and through parts are provided in each of the plurality of layers of the second insulating layer. At this time, a pad such as a land may not be provided between the through parts that are vertically overlapped with each other. Therefore, the embodiment can simplify a process for forming the through electrode and improve the product yield. Furthermore, the embodiment may allow centers of a in horizontal direction of a plurality of through parts overlapping each other in a vertical direction to be misaligned from each other, thereby improving the degree of design freedom.

In addition, the embodiment can be advantageous in selecting a de-smear process conditions since it is not necessary to consider damage to the first insulating layer in the de-smear process. Through this, the embodiment can improve the adhesion between the second circuit pattern layer disposed on the second insulating layer and the second insulating layer. Specifically, the cavity may be formed together with the through hole in a process of forming a through hole corresponding to the second through electrode of the second insulating layer. Through this, the embodiment may arrange the second circuit pattern layer on the second insulating layer after the de-smear process. Therefore, the embodiment may perform the de-smear process under conditions that can improve the adhesion with the second circuit pattern layer by being advantageous in selecting the conditions of the de-smear process. Through this, the embodiment may improve the adhesion between the second insulating layer and the second circuit pattern layer.

In addition, the first circuit pattern portion may include a first electrode pad on which a connecting member is disposed and a dummy electrode other than the first electrode pad. In addition, the dummy electrode may protect the upper surface of the first region of the first insulating layer while improving the rigidity and heat dissipation characteristics of the circuit board. Accordingly, the embodiment may improve the product reliability of the circuit board and the semiconductor package including the same. In addition, the embodiment includes a through part passing through the first insulating layer and connected to the dummy electrode. In addition, the embodiment may enable heat transmitted from the dummy electrode to be dissipated to an outside through the through part. Through this, the embodiment can further improve the heat dissipation characteristics of the circuit board. Through this, the embodiment can improve operational reliability of the circuit board and the semiconductor package including the same.

In addition, the first circuit pattern portion includes a connection pattern electrically connected to the first electrode pad. In addition, the connection pattern can directly connect between a plurality of electrode pads respectively disposed in the first region and the second region of the first insulating layer. That is, the embodiment arranges the connection pattern directly connecting the first electrode pad and the second electrode pad on the first insulating layer. Through this, the embodiment can reduce a signal transmission distance between the first electrode pad and the second electrode pad. Furthermore, the embodiment can minimize the signal transmission loss due to the reduction in the signal transmission distance. Accordingly, the embodiment can improve the electrical characteristics of the circuit board and the semiconductor package including the same. Furthermore, the embodiment can improve the circuit integration of the circuit board.

### [Description of Drawings]

FIG. 1a is a cross-sectional view showing a semiconductor package according to a first embodiment.
FIG. 1b is a cross-sectional view showing a semiconductor package according to a second embodiment.
FIG. 1c is a cross-sectional view showing a semiconductor package according to a third embodiment.
FIG. 1d is a cross-sectional view showing a semiconductor package according to a fourth embodiment.
FIG. 1e is a cross-sectional view showing a semiconductor package according to a fifth embodiment.
FIG. 1f is a cross-sectional view showing a semiconductor package according to a sixth embodiment.
FIG. 1g is a cross-sectional view showing a semiconductor package according to a seventh embodiment.
FIG. 2 is a cross-sectional view illustrating a circuit board of a first embodiment.
FIG. 3 is a plan view in which some components are removed from the circuit board of FIG. 2.
FIG. 4 is a cross-sectional view taken along a direction A-A' of FIG. 2 according to an embodiment.
FIG. 5 is a cross-sectional view taken along a direction A-A' of FIG. 2 according to another embodiment.
FIG. 6 is a cross-sectional view illustrating a first modified example of the circuit board of FIG. 2.
FIG. 7 is a plan view in which some components are removed from the circuit board of FIG. 6.
FIG. 8 is a cross-sectional view illustrating a second modified example of the circuit board of FIG. 2.
FIG. 9 is a cross-sectional view illustrating a circuit board according to a second embodiment.
FIG. 10 is a cross-sectional view illustrating a circuit board according to a third embodiment.
FIG. 11 is a plan view in which some components are removed from the circuit board of FIG. 10.
FIG. 12 is a cross-sectional view illustrating a circuit board according to a fourth embodiment.
FIG. 13 is a plan view in which some components are removed from the circuit board of FIG. 12.
FIG. 14 is a view illustrating a semiconductor package including the circuit board of FIG. 2.
FIGS. 15 to 20 are views showing a method of manufacturing the circuit board of FIG. 2 according to an embodiment in order of processes.
FIG. 21 is a cross-sectional view illustrating a circuit board of a fifth embodiment.
FIG. 22 is a plan view in which some components are removed from the circuit board of FIG. 21.
FIG. 23 is a cross-sectional view taken along a direction A-A' of FIG. 21 according to an embodiment.
FIG. 24 is a view showing a planar shape of a second through electrode of FIG. 21.
FIG. 25 is a view illustrating a planar shape of a cavity of FIG. 21.
FIG. 26 is a cross-sectional view illustrating a circuit board according to a sixth embodiment.
FIG. 27 is a cross-sectional view taken along a direction A-A' of FIG. 21 according to a seventh embodiment.
FIG. 28 is a cross-sectional view taken along a direction A-A' of FIG. 21 according to an eighth embodiment.
FIG. 29 is a cross-sectional view illustrating a circuit board according to a ninth embodiment.
FIG. 30 is a cross-sectional view illustrating a circuit board according to a tenth embodiment.
FIG. 31 is a cross-sectional view illustrating a circuit board according to an eleventh embodiment.
FIG. 32 is a cross-sectional view illustrating a circuit board according to a twelfth embodiment.
FIG. 33 a plan view in which some components are omitted from the circuit board of FIG. 32.
FIG. 34 is a cross-sectional view illustrating a circuit board according to a thirteenth embodiment.
FIG. 35 is a plan view in which some components are omitted from the circuit board of FIG. 21.
FIGS. 36 to 41 are views showing a method of manufacturing the circuit board of FIG. 21 in order of processes.

### [Best Mode]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present disclosure, the terms such as first, second, A, B, (a), and (b) may be used.

These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

### -Electronic device-

Before describing the embodiment, an electronic device to which the semiconductor package of the embodiment is applied will be briefly described. The electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor chip in the form of an integrated circuit (IC) in which hundreds to millions of devices are integrated in one semiconductor chip. The semiconductor device may be a logic chip, a memory chip, or the like. The logic chip may be a central processor (CPU), a graphics processor (GPU), or the like. For example, the logic chip may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far.

The memory chip may be a stack memory such as HBM. The memory chip may also include a memory chip such as volatile memory (e.g., DRAM), nonvolatile memory (e.g., ROM), flash memory, and the like.

On the other hand, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package on Package) and SIP (System in Package), but is not limited thereto.

In addition, the electronic device may be a smart phone, a personal digital assistant, a digital video camera, a digital still camera, a vehicle, a high-performance server, a network system, a computer, a monitor, a tablet, a laptop, a netbook, a television, a video game, a smart watch, an automotive, or the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later.

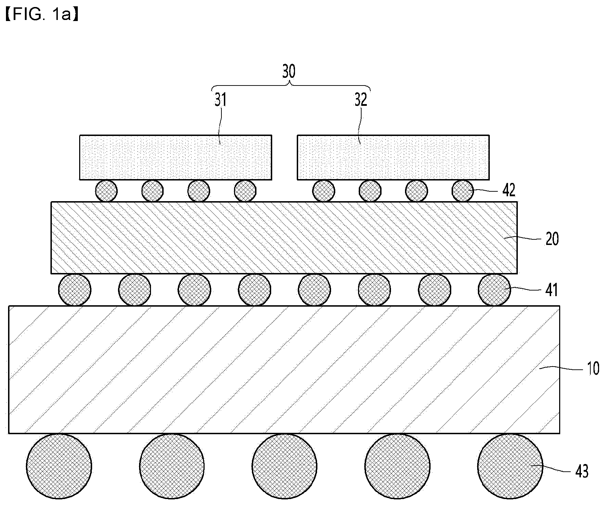

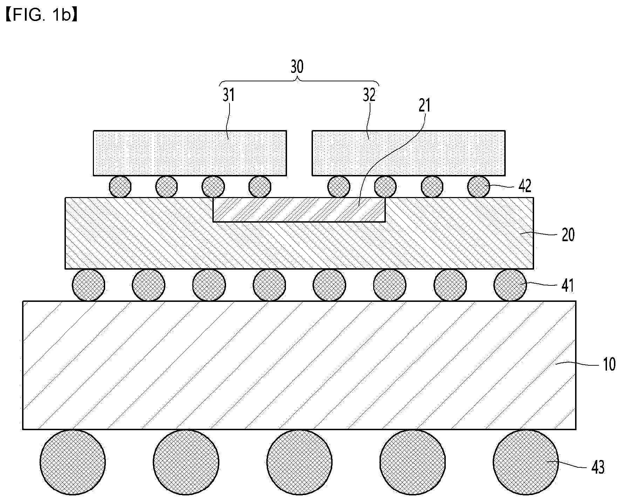

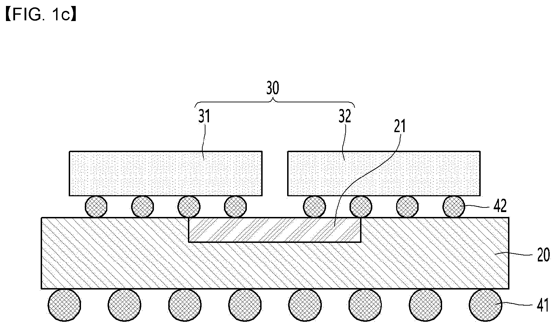

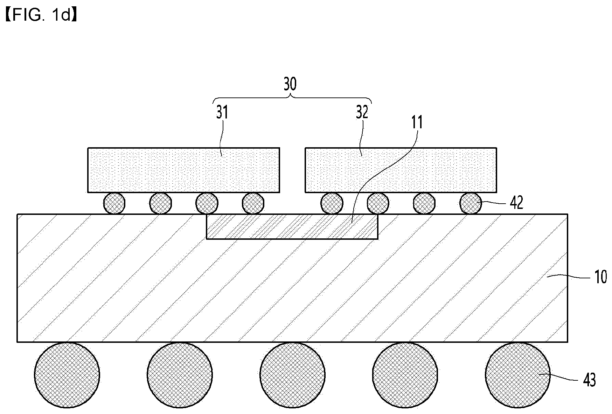

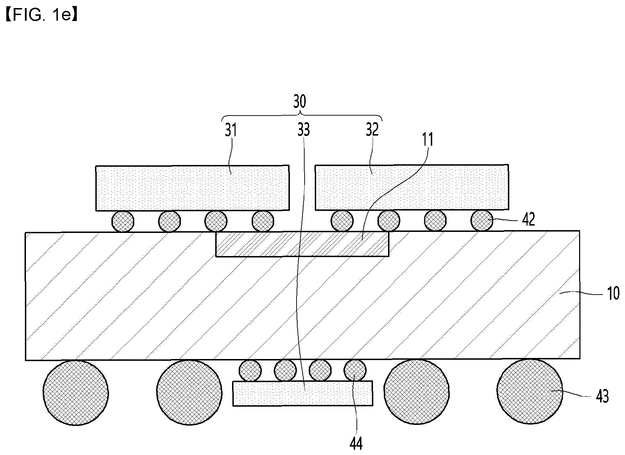

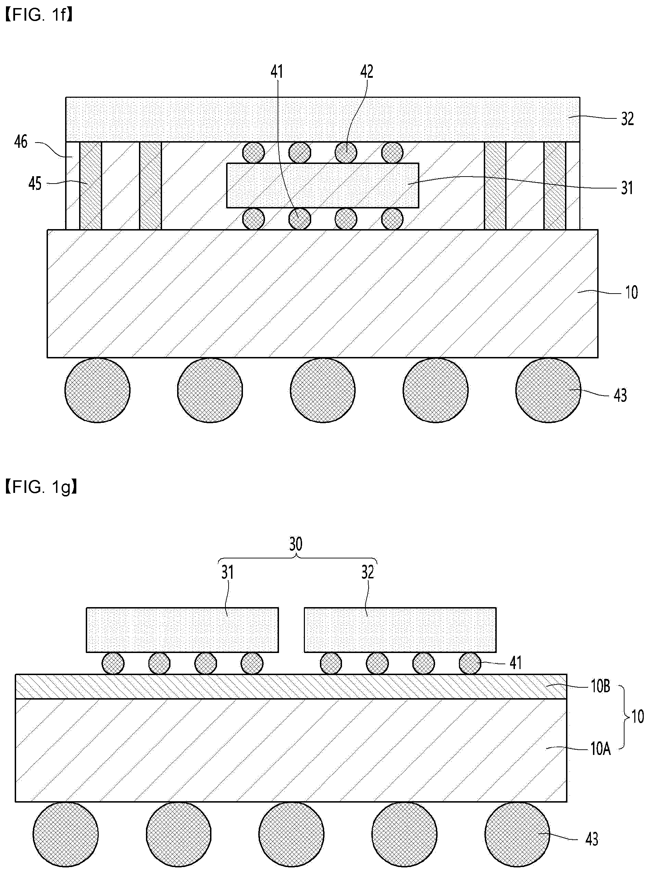

FIG. 1a is a cross-sectional view showing a semiconductor package according to a first embodiment, FIG. 1b is a cross-sectional view showing a semiconductor package according to a second embodiment, FIG. 1c is a cross-sectional view showing a semiconductor package according to a third embodiment, FIG. 1d is a cross-sectional view showing a semiconductor package according to a fourth embodiment, FIG. 1e is a cross-sectional view showing a semiconductor package according to a fifth embodiment, FIG. 1f is a cross-sectional view showing a semiconductor package according to a sixth embodiment, and FIG. 1g is a cross-sectional view showing a semiconductor package according to a seventh embodiment.

Referring to FIG. 1a, the semiconductor package according to the first embodiment may include a first circuit board 10, a second circuit board 20, and a semiconductor device 30.

The first circuit board 10 means a semiconductor package substrate.

For example, the first circuit board 10 may provide a space to which at least one external circuit board is coupled. The external circuit board may refer to a second circuit board 20 coupled to the first circuit board 10. Also, the external circuit board may refer to a main board included in an electronic device coupled to a lower portion of the first circuit board 10.

Also, although not shown in the drawing, the first circuit board 10 may provide a space in which at least one semiconductor device is mounted.

The first circuit board 10 includes at least one insulating layer, a circuit pattern layer disposed on the at least one insulating layer, and a through electrode passing through the at least one insulating layer.

A second circuit board 20 is disposed on the first circuit board 10.

The second circuit board 20 may be an interposer. For example, the second circuit board 20 may provide a space in which at least one semiconductor device is mounted. The second circuit board 20 may be connected to the at least one semiconductor device 30. For example, the second circuit board 20 may provide a space in which the first semiconductor device 31 and the second semiconductor device 32 are mounted. The second circuit board 20 may electrically connect the first and second semiconductor devices 31 and 32 and the first circuit board 10 while electrically connecting the first semiconductor device 31 and the second semiconductor device 32. That is, the second circuit board 20 may perform a horizontal connection function between a plurality of semiconductor devices and a vertical connection function between the semiconductor devices and a package circuit substrate.

FIG. 1a illustrates that the first and second semiconductor devices 31 and 32 are disposed on the second circuit board 20, but is not limited thereto. For example, one semiconductor device may be disposed on the second circuit board 20, or alternatively, three or more semiconductor devices may be disposed.

The second circuit board 20 may be disposed between at least one semiconductor device 30 and the first circuit board 10.

In an embodiment, the second circuit board 20 may be an active interposer that functions as a semiconductor device. When the second circuit board 20 functions as a semiconductor device, the semiconductor package of the embodiment may have a structure that is vertically stacked on the first circuit board 10 and may have functions of multiple logic chips. Having the function of a logic chip may mean that it may have functions of an active device and a passive device. In a case of an active device, characteristics of current and voltage may not be linear unlike a passive device, and in a case of an active interposer, it may have the function of an active device. In addition, the active interposer may perform a function of a corresponding logic chip while performing a signal transmission function between a second logic chip disposed thereon and the first circuit board 10.

According to another embodiment, the second circuit board 20 may be a passive interposer. For example, the second circuit board 20 may function as a signal relay between the semiconductor device 30 and the first circuit board 10, and can have a passive device function such as a resistor, capacitor, or inductor. For example, a number of terminals of the semiconductor device 30 is gradually increasing due to 5G, Internet of Things (IOT), increased image quality, and increased communication speed. That is, the number of terminals provided in the semiconductor device 30 increases, thereby reducing the width of the terminals or an interval between the plurality of terminals. In this case, the first circuit board 10 is connected to the main board of the electronic device. There is a problem in that the thickness of the first circuit board 10 increases or the layer structure of the first circuit board 10 becomes complicated in order for the electrodes provided on the first circuit board 10 to have a width and an interval to be respectively connected to the semiconductor device 30 and the main board. Accordingly, in the first embodiment, the second circuit board 20 is disposed on the first circuit board 10 and the semiconductor device 30. In addition, the second circuit board 20 may include electrodes having a fine width and an interval corresponding to the terminals of the semiconductor device 30.

The semiconductor package includes a first connecting member 41 positioned between a first circuit board 10 and a second circuit board 20. The first connecting member 41 electrically connects the first circuit board 10 and the second circuit board 20 while bonding the second circuit board 20 to the first circuit board 10.

The semiconductor package may include a second connecting member 42 disposed between the second circuit board 20 and the semiconductor device 30. The second connecting member 42 may electrically connect the semiconductor device 30 and the second circuit board 20 while bonding the semiconductor device 30 to the second circuit board 20.

The semiconductor package includes a third connecting member 43 disposed on a lower surface of the first circuit board 10. The third connecting member 43 may electrically connect the first circuit board 10 and the main board while bonding the first circuit board 10 to the main board.

At this time, the first connecting member 41, the second connecting member 42, and the third connecting member 43 may electrically connect between the plurality of components by using at least one bonding method of wire bonding, solder bonding and metal-to-metal direct bonding. That is, since the first connecting member 41, the second connecting member 42, and the third connecting member 43 have a function of electrically connecting a plurality of components, when the metal-to-metal direct bonding is used, the connecting part of the semiconductor package may be understood as an electrically connected portion, not a solder or wire.

The wire bonding method may refer to electrically connecting a plurality of components using a conductive wire such as gold (Au). Also, the solder bonding method may electrically connect a plurality of components using a material containing at least one of Sn, Ag, and Cu. In addition, the metal-to-metal direct bonding method may refer to recrystallization by applying heat and pressure between a plurality of components without the presence of solder, wire, conductive adhesive, etc. In addition, to directly bond between the plurality of components. In addition, the metal-to-metal direct bonding method may refer to a bonding method by the second connecting member 42. In this case, the second connecting member 42 may mean a metal layer formed between a plurality of components by the recrystallization.

Specifically, the first connecting member 41, the second connecting member 42, and the third connecting member 43 may couple a plurality of components to each other by a thermal compression (TC) bonding method. The TC bonding may refer to a method of directly bonding a plurality of components by applying heat and pressure to the first connecting member 41, the second connecting member 42, and the third connecting member 43.

In this case, at least one of the first circuit board 10 and the second circuit board 20 may include a protrusion provided in the electrode on which the first connecting member 41, the second connecting member 42, and the third connecting member 43 are disposed. The protrusion may protrude outward from the first circuit board 10 or the second circuit board 20.

The protrusion may be referred to as a bump, or a post, or a pillar. Preferably, the protrusion may refer to an electrode on which a second connecting member 42 for bonding with the semiconductor device 30 is disposed among the electrodes of the second circuit board 20. That is, as the pitch of the terminals of the semiconductor device 30 becomes finer, a short circuit may occur between the plurality of second connecting parts 1420 that are respectively connected to the plurality of terminals of the semiconductor device 30 by a conductive adhesive such as a solder. Therefore, in the embodiment, thermal compression bonding may be performed to reduce a volume of the second connecting member 42, and in order to secure diffusion prevention and alignment to prevent an intermetallic compound (IMC) formed between a conductive adhesive such as solder and a protrusion from diffusing into the interposer and/or the circuit board, a protrusion may be included in the electrode of the second circuit board 20 on which the second connecting member 42 is disposed.

Referring to FIG. 1b, the semiconductor package of the second embodiment is different from the semiconductor package of the first embodiment in that the connection member 21 is disposed on the second circuit board 20. Recently, the number of signals that semiconductor devices must process is increasing, and accordingly, the size of semiconductor devices is becoming larger. In addition, such large-area semiconductor devices become a problem of lowering the yield of semiconductor devices. Therefore, there is a trend of dividing the pattern size or functional part of semiconductor devices, arranging chip-lets on a circuit board, and burying a connecting member 21 that has the function of electrically connecting the divided chip-lets inside the circuit board. However, the connection member 21 is not limited thereto, and can also connect semiconductor devices with other functions such as memory. For example, the connection member 21 may include a redistribution layer. The connection member 21 may perform a function of electrically connecting a plurality of semiconductor devices horizontally to each other. For example, since the area that a semiconductor device should generally have been too large, the connection member 21 may include a redistribution layer. Since the semiconductor package and the semiconductor device have a large difference in a width or spacing of the circuit pattern, etc., a buffering role of the circuit pattern for electrical connection is required. The buffering role may mean having a size between a width or spacing of the circuit pattern of the semiconductor package and a width or spacing of the circuit pattern of the semiconductor device, and the redistribution layer may include a function of performing the buffering role.

In an embodiment, the connection member 21 may include a silicon material, and include a silicon circuit board and a redistribution layer disposed on the silicon circuit board.

In another embodiment, the connection member 21 may include an organic material. For example, the connection member 21 includes an organic circuit substrate including an organic material instead of the silicon circuit board.

The connection member 21 may be embedded in the second circuit board 20, but is not limited thereto. For example, the connection member 21 may be disposed on the second circuit board 20 to have a protruding structure. In addition, the second circuit board 20 may include a cavity, and the connection member 21 may be disposed in the cavity of the second circuit board 20. The connection member 21 may horizontally connect a plurality of semiconductor devices disposed on the second circuit board 20.

Referring to FIG. 1c, the semiconductor package according to the third embodiment may include a second circuit board 20 and a semiconductor device 30. In this case, the semiconductor package of the third embodiment has a structure in which the first circuit board 10 is removed compared to the semiconductor package of the second embodiment.

That is, the second circuit board 20 of the third embodiment may function as a package substrate while performing an interposer function.

The first connecting member 41 disposed on the lower surface of the second circuit board 20 may couple the second circuit board 20 to the main board of the electronic device.

Referring to FIG. 1d, the semiconductor package according to the fourth embodiment may include a first circuit board 10 and a semiconductor device 30.

In this case, the semiconductor package of the fourth embodiment has a structure in which the second circuit board 20 is removed compared to the semiconductor package of the second embodiment.

That is, the first circuit board 10 of the fourth embodiment can function as a package circuit board while also performing the function of connecting the semiconductor device 30 and a main board. To this end, the first circuit board 10 may include a connection member 11 for connecting the plurality of semiconductor devices. The connection member 11 may be a silicon bridge or an organic material bridge connecting a plurality of semiconductor devices.

Referring to FIG. 1e, the semiconductor package of the fifth embodiment further includes a third semiconductor device 1330 compared to the semiconductor package of the fourth embodiment.

To this end, a fourth connecting member 44 may be disposed on the lower surface of the first circuit board 10. In addition, a third semiconductor device 33 may be disposed on the fourth connecting member 44. That is, the semiconductor package of the fifth embodiment may have a structure in which semiconductor devices are mounted on upper and lower sides, respectively.

In this case, the third semiconductor device 33 may have a structure disposed on the lower surface of the second circuit board 20 in the semiconductor package of FIG. 1c.

Referring to FIG. 1f, the semiconductor package according to the sixth embodiment includes a first circuit board 10.

A first semiconductor device 31 may be disposed on the first circuit board 10. To this end, a first connecting member 41 may be disposed between the first circuit board 10 and the first semiconductor device 31.

In addition, the first circuit board 10 includes a conductive bonding portion 45. The conductive bonding portion 45 may further protrude from the first circuit board 10 toward the second semiconductor device 32. The conductive bonding portion 45 may be referred to as a bump or, alternatively, may also be referred to as a post. The conductive bonding portion 45 may be disposed to have a protruding structure on an electrode disposed at an uppermost side of the first circuit board 10.

A second semiconductor device 32 may be disposed on the conductive bonding portion 45. In this case, the second semiconductor device 32 may be connected to the first circuit board 10 through the conductive bonding portion 45. In addition, a second connecting member 42 may be disposed on the first semiconductor device 31 and the second semiconductor device 32.

Accordingly, the second semiconductor device 32 may be electrically connected to the first semiconductor device 31 through the second connecting member 42.

That is, the second semiconductor device 32 may be connected to the first circuit board 10 through the conductive bonding portion 45, and may be also connected to the first semiconductor device 31 through the second connecting member 42.

In this case, the second semiconductor device 32 may receive a power signal and/or electric power through the conductive bonding portion 45. Also, the second semiconductor device 32 may transmit and receive a communication signal to and from the first semiconductor device 31 through the second connecting member 42.

The semiconductor package according to the sixth embodiment provides a power signal and/or electric power to the second semiconductor device 32 through the conductive bonding portion 45, thereby providing sufficient power for driving the second semiconductor device 32 or enabling smooth control of a power operation.

Accordingly, the embodiment may improve the driving characteristics of the second semiconductor device 32. That is, the embodiment may solve a problem of insufficient power provided to the second semiconductor device 32. Furthermore, in the embodiment, at least one of a power signal, an electric power, and a communication signal of the second semiconductor device 32 are provided through different paths through the conductive bonding portion 45 and the second connecting member 42. Through this, the embodiment can solve the problem that the communication signal is lost due to the power signal. For example, the embodiment may minimize mutual interference between communication signals of power signals.

Meanwhile, the second semiconductor device 32 in the sixth embodiment may have a POP (Package On Package) structure in which a plurality of package substrates are stacked and may be disposed on the first circuit board 10. For example, the second semiconductor device 32 may be a memory package including a memory chip. In addition, the memory package may be coupled on the conductive bonding portion 45. In this case, the memory package may not be connected to the first semiconductor device 31.

Meanwhile, the semiconductor package in the sixth embodiment may include a molding member 46. The molding member 46 may be disposed between the first circuit board 10 and the second semiconductor device 32. For example, the molding member 46 may mold the first connecting member 41, the second connecting member 42, the first semiconductor device 31, and the conductive bonding portion 45.

Referring to FIG. 1g, the semiconductor package according to the seventh embodiment may include a first circuit board 10, a first connecting member 41, a first connecting member 41, a semiconductor device 30, and a third connecting member 43. In this case, the semiconductor package of the seventh embodiment is different from the semiconductor package of the fourth embodiment in that the first circuit board 10 includes a plurality of substrate circuit layers while the connection member 11 is removed.

The first circuit board 10 includes a plurality of circuit board layers. For example, the first circuit board 10 may include a first circuit board layer 10A corresponding to a package substrate and a second circuit board layer 10B corresponding to a redistribution layer of the connection member.

In other words, the semiconductor package of the seventh embodiment may include a first circuit board layer 10A and a second circuit board layer 10B in which the first circuit board (package circuit board, 10) and the second circuit board (interposer, 20) disclosed in FIG. 1a are integrally formed. A material of the insulating layer of the second circuit board layer 10B may be different from a material of an insulating layer of the first circuit board layer 10A. For example, the material of an insulating layer of the second circuit board layer 10B may include a photocurable material. For example, the second circuit board layer 10B may be a photo imageable dielectric (PID). In addition, since the second circuit board layer 10B includes a photocurable material, it is possible to miniaturize the electrode. Accordingly, in the seventh embodiment, the second circuit board layer 10B may be formed by sequentially stacking an insulating layer of a photo-curable material on the first circuit board layer 10A and forming a miniaturized electrode on the insulating layer of the photo-curable material. Accordingly, the second circuit board layer 10B may include a redistribution layer function including a micro-electrode and may include a function of horizontally connecting a plurality of semiconductor devices 31 and 32.

Hereinafter, a circuit board of an embodiment will be described.

Hereinafter, embodiments will be described in detail with reference to the accompanying drawings. However, regardless of reference numerals, same or corresponding components are assigned with same reference numerals, and redundant descriptions thereof will be omitted.

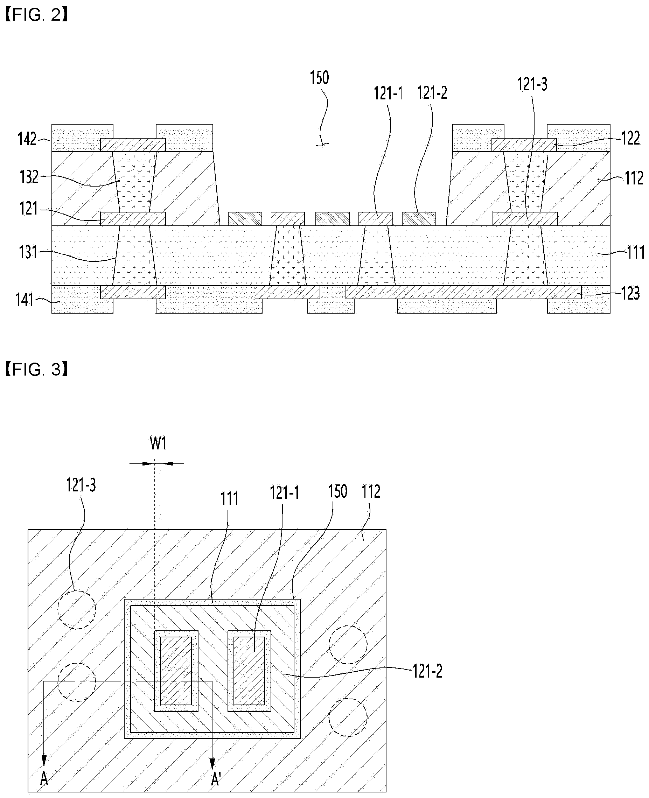

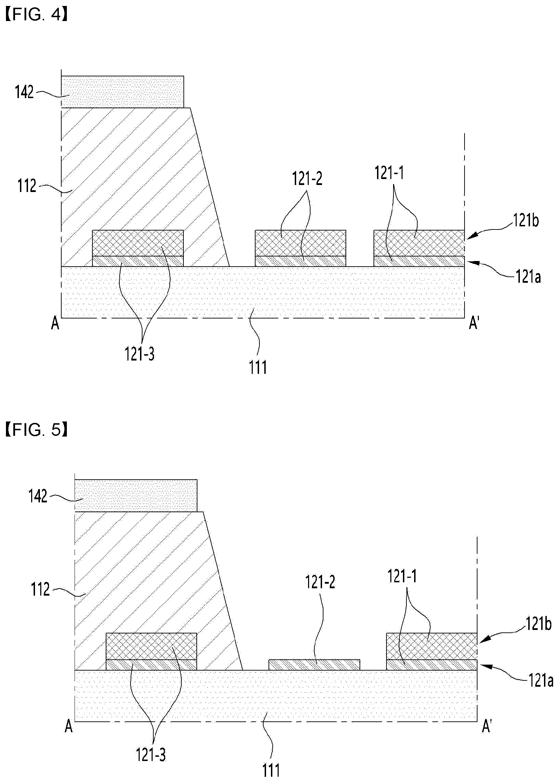

FIG. 2 is a cross-sectional view illustrating a circuit board of a first embodiment, FIG. 3 is a plan view in which some components are removed from the circuit board of FIG. 2, FIG. 4 is a cross-sectional view taken along a direction A-A' of FIG. 2 according to an embodiment, and FIG. 5 is a cross-sectional view taken along a direction A-A' of FIG. 2 according to another embodiment.

Before describing the circuit board of an embodiment, the circuit board described below may mean a circuit board included in a semiconductor package of any one of the embodiments of FIGS. 1a to 1g. Preferably, the circuit board of an embodiment described below may be the first circuit board 10 and/or the second circuit board 20 of FIGS. 1a to 1g. The first circuit board 10 and/or the second circuit board 20 may include a cavity.

At this time, a connection member may be disposed in the cavity. When the circuit board is the first circuit board 10, the connection member may be any one of the connection member, the second circuit board, and the semiconductor device. In addition, when the circuit board is the second circuit board 20, the connection member may be any one of the semiconductor device and the connection member.

Referring to FIG. 2, the circuit board of the embodiment includes a plurality of insulating layers. Each of the plurality of insulating layers may have a single-layer structure, or may be composed of multiple layers. Specifically, the circuit board may include a first insulating layer 111 and a second insulating layer 112. At this time, the first insulating layer 111 may be provided as a single layer as illustrated in FIG. 2, or may be provided as multiple layers. The second insulating layer 112 is disposed on the first insulating layer 111. The second insulating layer 112 may be provided as a single layer or may be provided as multiple layers. The second insulating layer 112 may include a cavity 150. In addition, when the second insulating layer 112 is provided as multiple layers, the cavity 150 may pass through multiple layers of the second insulating layer 112. However, for convenience of explanation, a following description will assume that each of the first insulating layer 111 and the second insulating layer 112 are provided as one layer.

The first insulating layer 111 and the second insulating layer 112 may include different insulating materials. For example, the first insulating layer 111 may include a thermosetting resin. The second insulating layer 112 may include a photocurable resin.

The first insulating layer 111 may include chemically strengthened/semi-strengthened glass such as soda lime glass or aluminosilicate glass. For example, the first insulating layer 111 may include a strengthened or flexible plastic such as polyimide (PI), polyethylene terephthalate (PET), propylene glycol (PPG), or polycarbonate (PC). For example, the first insulating layer 111 may include sapphire. For example, the first insulating layer 111 may include an optically isotropic film. For example, the first insulating layer 111 may include COC (Cyclic Olefin Copolymer), COP (Cyclic Olefin Polymer), optically isotropic polycarbonate (PC), or optically isotropic polymethyl methacrylate (PMMA). For example, the first insulating layer 111 may be formed of a material including an inorganic filler and an insulating resin. For example, the first insulating layer 111 may have a structure in which an inorganic filler of silica or alumina is disposed in a thermosetting resin or a thermoplastic resin.

The second insulating layer 112 may include an insulating material different from an insulating material of the first insulating layer 111. Preferably, the second insulating layer 112 may include a photocurable resin. The photocurable resin enables a formation of a cavity through an exposure and development process, and thus, a stopper required in a process of forming the cavity may be removed. A content of ceramic particles such as SiO₂ provided in the second insulating layer 112 including the photocurable resin may be higher than the content of ceramic particles provided in the first insulating layer 111 including the thermosetting resin. Based on this, an interface between the photocurable resin and the thermosetting resin may be distinguished. For example, when performing XPS (X-ray Photoelectron Spectroscopy) analysis of a photocurable resin, relatively high power peak values can be detected in two of acrylic and epoxy. In addition, when performing XPS analysis of a thermosetting resin, peak values can be detected only in epoxy.

Each of the first insulating layer 111 and the second insulating layer 112 may have a thickness in a range of 10 µm to 60 µm. If the thickness of the first insulating layer 111 and the second insulating layer 112 is less than 10 µm, the circuit pattern layer included in the circuit board may not be stably protected. If the thickness of each of the first insulating layer 111 and the second insulating layer 112 exceeds 60 µm, an overall thickness of the circuit board may increase. In addition, if the thickness of each of the first insulating layer 111 and the second insulating layer 112 exceeds 60 µm, a thickness of the circuit pattern layer or the through electrode also increases accordingly, and a loss of the signal transmitted through the circuit pattern may increase accordingly. At this time, the thickness of the first insulating layer 111 and the second insulating layer 112 may correspond to a distance in a thickness direction between the circuit pattern layers disposed in different layers. For example, the thickness of the first insulating layer 111 may mean a vertical distance between a lower surface of the first circuit pattern layer 121 and an upper surface of the third circuit pattern layer 123. For example, the thickness of the second insulating layer 112 may mean a vertical straight distance in the thickness direction between an upper surface of the first circuit pattern layer 121 and a lower surface of the second circuit pattern layer 122.

The second insulating layer 112 may include a cavity 150. The cavity 150 may passes through an upper surface and a lower surface of the second insulating layer 112. The cavity 150 may include a lower surface and a side wall. The lower surface of the cavity 150 may mean an upper surface of the first insulating layer 111 that vertically overlaps the cavity 150. In addition,, the side wall of the cavity 150 may mean a side wall of the second insulating layer 112 including the cavity 150.

The side wall of the cavity 150 may have a slope. For example, the side wall of the cavity 150 may have a slope in which a width of the cavity 150 decreases from the upper surface toward the lower surface of the second insulating layer 112. However, the embodiment is not limited thereto. For example, the side wall may have a slope in which the width of the cavity 150 decreases from the lower surface of the second insulating layer 112 toward the upper surface of the second insulating layer 112. Furthermore, although the drawing illustrates the side wall as having one slope, the embodiment is not limited thereto. For example, the side wall may be provided to be inclined with a plurality of different slopes.

The upper surface of the first insulating layer 111 may be divided into a plurality of regions. For example, the first insulating layer 111 may include a first region R1 vertically overlapping the cavity 150. In this case, when the cavity 150 has different widths in a thickness direction of the second insulating layer 112, the first region R1 may mean a region that vertically overlaps a lower region of the cavity 150 corresponding to a lower portion of the side wall. For example, the first region R1 may mean a region of the upper surface of the first insulating layer 111 that does not contact the second insulating layer 112.

In addition, the first insulating layer 111 may include a second region R2 that does not vertically overlap the cavity 150. The second region R2 may mean a region of the upper surface of the first insulating layer 111 that is covered by the second insulating layer 112.

A circuit pattern layer is disposed on surfaces of the first insulating layer 111 and the second insulating layer 112.

For example, a first circuit pattern layer 121 may be disposed between the upper surface of the first insulating layer 111 and the lower surface of the second insulating layer 112. For example, a second circuit pattern layer 122 may be disposed on the upper surface of the second insulating layer 112. For example, a third circuit pattern layer 123 may be disposed on a lower surface of the first insulating layer 111. The first circuit pattern layer 121 may be disposed on the first insulating layer 111. For example, the first circuit pattern layer 121 may protrude on the upper surface of the first insulating layer 111. The second circuit pattern layer 122 may protrude on the upper surface of the second insulating layer 112. The second circuit pattern layer 122 may refer to an uppermost circuit pattern layer disposed at an uppermost side of the circuit board. The third circuit pattern layer 123 may protrude below the lower surface of the first insulating layer 111. The third circuit pattern layer 123 may refer to a lowermost circuit pattern layer disposed at a lowermost side of the circuit board.

The first circuit pattern layer 121, the second circuit pattern layer 122, and the third circuit pattern layer 123 may each include electrode pads and traces (or connection patterns) according to their functions. The electrode pads may be mounting electrode pads on which devices or chips are mounted, or terminal electrode pads connected to an external circuit board. The traces may be long signal wiring lines connecting between a plurality of electrode pads. The traces are micropatterns having a width smaller than that of the electrode pads. For example, a spacing between the plurality of traces in the embodiment may be in a range of 2 µm to 15 µm, and a line width of each trace may be in the range of 2 µm to 15 µm.

The above-described circuit pattern layers may be formed of at least one metal material selected from gold (Au), silver (Ag), platinum (Pt), titanium (Ti), tin (Sn), copper (Cu), and zinc (Zn). In addition, the circuit pattern layers may be formed of a paste or solder paste including at least one metal material selected from gold (Au), silver (Ag), platinum (Pt), titanium (Ti), tin (Sn), copper (Cu), and zinc (Zn) having excellent bonding strength. Preferably, the first circuit pattern layer 121, the second circuit pattern layer 122, and the third circuit pattern layer 123 may be formed of copper (Cu) having high electrical conductivity and relatively low price.

The first circuit pattern layer 121, the second circuit pattern layer 122, and the third circuit pattern layer 123 may each have a thickness in a range of 10 µm to 25 µm. If the thickness of each of the first circuit pattern layer 121, the second circuit pattern layer 122, and the third circuit pattern layer 123 is less than 10 µm, a resistance of the circuit pattern may increase, and thus signal transmission efficiency may decrease. For example, if the thickness of each of the first circuit pattern layer 121, the second circuit pattern layer 122, and the third circuit pattern layer 123 is less than 10 µm, signal transmission loss may increase. For example, if the thickness of each of the first circuit pattern layer 121, the second circuit pattern layer 122, and the third circuit pattern layer 123 exceeds 25 µm, a line width of the circuit patterns may increase, and thus an overall volume of the circuit board may increase.

The first circuit pattern layer 121, the second circuit pattern layer 122, and the third circuit pattern layer 123 may be manufactured using conventional manufacturing processes of printed circuit boards, such as an additive process, a subtractive process, a modified semi-additive process (MSAP), and a semi-additive process (SAP), and a detailed description thereof will be omitted here.

Referring to FIG. 3, the first circuit pattern layer 121 may include a first electrode pad 121-1 disposed on a first region R1 of the first insulating layer 111. The first electrode pad 121-1 may vertically overlap with the cavity 150. Therefore, the first electrode pad 121-1 may not contact the second insulating layer 112.

The first circuit pattern layer 121 may include a second electrode pad 121-2 disposed on a second region R2 of the first insulating layer 111. The second electrode pad 121-2 may not vertically overlap with the cavity 150. Therefore, the second electrode pad 121-2 may be covered with the second insulating layer 112.

In addition, the first circuit pattern layer 121 may further include a dummy electrode 121-2 disposed on the first region R1 of the first insulating layer 111. The dummy electrode 121-2 may be disposed on a region of the first region R1 of the first insulating layer 111 where the first electrode pad 121-1 is not disposed.

For example, the circuit board of the first embodiment may have a dummy electrode 121-2 disposed on the first region R1 of the first insulating layer 111 and spaced apart from the first electrode pad 121-1. The dummy electrode 121-2 may have a function of protecting a portion of the first region R1 of the first insulating layer 111 where the first electrode pad 121-1 is not disposed. For example, the dummy electrode 121-2 may be referred to as a protective electrode or barrier electrode that protects the first region R1 of the first insulating layer 111.

That is, in a general circuit board, only the first electrode pad 121-1 is disposed on the first region R1 of the first insulating layer 111. At this time, if a de-smear process is performed after the formation of the cavity 150 without the dummy electrode 121-2 being disposed, a portion of the first region R1 of the first insulating layer 111 where the first electrode pad 121-1 is not disposed may also be etched together. In addition, if the first region R1 of the first insulating layer 111 is etched in the de-smear process, a problem may occur in which a glass fiber included in the first insulating layer 111 is exposed through the cavity 150. In addition, the exposed glass fiber may cause reliability problems such as copper migration.

Therefore, the circuit board of the embodiment disposes a dummy electrode 121-2 in a portion of the first region R1 of the first insulating layer 111 where the first electrode pad 121-1 is not disposed. In addition, the dummy electrode 121-2 can prevent the etching of the first region R1 of the first insulating layer 111 from occurring during the de-smear process. Through this, the embodiment can prevent reliability problems such as copper migration occurring due to the etching of the first region R1 of the first insulating layer 111. Therefore, the embodiment can improve the electrical reliability of the circuit board.

Accordingly, the embodiment can be advantageous in selecting the de-smear process conditions since it is not necessary to consider damage to the first insulating layer 111 during the de-smear process. Through this, the embodiment can improve the adhesion between the second circuit pattern layer 122 disposed on the second insulating layer 112 and the second insulating layer 112. Specifically, the cavity 150 can be formed together with a through hole in a process of forming a through hole corresponding to the second through electrode 132 of the second insulating layer 112. Through this, the embodiment can arrange the second circuit pattern layer 122 on the second insulating layer 112 after the de-smear process. Therefore, the embodiment can perform the de-smear process under conditions that can improve the adhesion with the second circuit pattern layer 122 by being advantageous in selecting the conditions of the de-smear process. Through this, the embodiment can improve the adhesion between the second insulating layer 112 and the second circuit pattern layer 122.

The dummy electrode 121-2 may be spaced apart from the first electrode pad 121-1 on the first region R1. For example, the dummy electrode 121-2 may be disposed to surround the first electrode pad 121-1 without contacting the first electrode pad 121-1. For example, the dummy electrode 121-2 may be spaced apart from the first electrode pad 121-1 by a first width W1. The first width W1 may satisfy a range of 10 µm to 30 µm. For example, the first width W1 may satisfy a range of 12 µm to 28 µm. For example, the first width W1 may satisfy a range of 15 µm to 25 µm.

If the first width W1 is less than 10 µm, when a connecting member is disposed on the first electrode pad 121-1, a problem may occur in which the connecting member and the dummy electrode 121-2 are connected. At this time, since the dummy electrode 121-2 is not electrically connected to other patterns of the first circuit pattern layer 121, even if the connecting member is connected to the dummy electrode 121-2, a problem such as a circuit short circuit does not occur. However, when the connecting member is connected to the dummy electrode 121-2, the signal transmission characteristics between the connecting member and the first circuit pattern layer 121 may be deteriorated. For example, if the first width W1 is less than 10 µm, the electrical characteristics of the circuit board may be deteriorated.

If the first width W1 exceeds 30 µm, an etching solution according to the de-smear process may penetrate into a gap between the first electrode pad 121-1 and the dummy electrode 121-2. In addition, when the etching solution penetrates, a problem may occur in which an upper surface of a separation space of the first insulating layer 111 is also etched.

In addition, the first circuit pattern layer 121 is disposed to occupy at least a certain area of a total area of the first region R1 of the first insulating layer 111. Specifically, the first circuit pattern layer 121 may include a first circuit pattern part disposed on the first region R1 of the first insulating layer 111 and a second circuit pattern part disposed on the second region R2. At this time, the first circuit pattern part may mean the first electrode pad 121-1 and the dummy electrode 121-2. In addition, the second circuit pattern part may mean the second electrode pad.

In addition, a planar area of the first circuit pattern part may satisfy a range of 50% to 90% of a planar area of the first region R1 of the first insulating layer 111. The planar area of the first circuit pattern part can satisfy a range of 50% to 90% of the planar area of the first region R1 of the first insulating layer 111. For example, the planar area of the first circuit pattern part can satisfy a range of 55% to 85% of the planar area of the first region R1 of the first insulating layer 111. For example, the planar area of the first circuit pattern part can satisfy a range of 60% to 85% of the planar area of the first region R1 of the first insulating layer 111. That is, a planar area of a portion of the first region R1 of the first insulating layer 111 that contacts the first circuit pattern layer 121 can satisfy a range of 50% to 90%, a range of 55% to 85%, or a range of 60% to 85% of a total planar area of the first region R1. That is, a plane area of a portion of the first region R1 of the first insulating layer 111 that does not come into contact with the first circuit pattern layer 121 can satisfy a range of 10% to 50%, a range of 15% to 45%, or a range of 15% to 40% of the total plane area of the first region R1.

If the plane area of the first circuit pattern part is less than 50% of the plane area of the first region R1 of the first insulating layer 111, a problem may occur in which the upper surface of the first region R1 of the first insulating layer 111 where the first circuit pattern part is not disposed is etched in the de-smear process after the formation of the cavity 150. In addition, if the planar area of the first circuit pattern part exceeds 90% of the planar area of the first region R1 of the first insulating layer 111, a problem may occur in which a part of the connecting member comes into contact with the dummy electrode 121-2 during a process of arranging the connecting member.

The dummy electrode 121-2 does not come into contact with the second insulating layer 112. The dummy electrode 121-2 may be disposed only on the first region R1 of the first insulating layer 111. Furthermore, the dummy electrode 121-2 may not come into contact with the side wall of the second insulating layer 112 having the cavity 150.

Again, referring to FIG. 2, the circuit board of the embodiment includes a through electrode. The through electrode may have a function of electrically connecting circuit pattern layers disposed on different layers to each other. The through electrode may also be referred to as a 'via'.

The through electrode passes through the first insulating layer 111 and the second insulating layer 112 included in the circuit board, and thus can electrically connect circuit patterns disposed on different layers. At this time, the through electrode may be formed by passing through only one insulating layer, or alternatively, may be formed by passing through at least two or more insulating layers in common.

For example, the circuit board includes a first through electrode 131. The first through electrode 131 may be formed by passing through the first insulating layer 111. The first through electrode 131 may electrically connect between the first circuit pattern layer 121 and the third circuit pattern layer 123. For example, an upper surface of the first through electrode 131 may be directly connected to the lower surface of the first circuit pattern layer 121. For example, a lower surface of the first through electrode 131 may be directly connected to the third circuit pattern layer 123.

Accordingly, the first circuit pattern layer 121 and the third circuit pattern layer 123 can be electrically connected to each other through the first through electrode 131 to transmit a signal.

At this time, the first through electrode 131 can include a first through part connected to the first electrode pad 121-1 and a second through part connected to the second electrode pad 121-2. In addition, since the dummy electrode 121-2 is disposed on the first region R1 of the first embodiment, the first electrode pad 121-1 and the second electrode pad 121-2 cannot be directly connected to each other on the first insulating layer 111. Therefore, the first electrode pad 121-1 and the second electrode pad 121-2 of the first embodiment can be electrically connected to each other through the first through part and the second through part of the first through electrode 131.

In addition, the circuit board includes a second through electrode 132. The second through electrode 132 may be formed by passing through the second insulating layer 112. The second through electrode 132 may electrically connect the first circuit pattern layer 121 and the second circuit pattern layer 122. For example, a lower surface of the second through electrode 132 may be directly connected to the first circuit pattern layer 121. For example, an upper surface of the second through electrode 132 may be directly connected to the second circuit pattern layer 122. Accordingly, the first circuit pattern layer 121 and the second circuit pattern layer 122 may be directly electrically connected to each other through the second through electrode 132 to transmit signals.

The first through electrode 131 and the second through electrode 132 can be formed by forming a through hole passing through the first insulating layer 111 and the second insulating layer 112 and filling an inside of the formed through hole with a conductive material.

The through hole can be formed by any one of mechanical, laser, and chemical processing methods. When the through hole is formed by mechanical processing, methods such as milling, drilling, and routing can be used, and when the through hole is formed by laser processing, a UV or CO₂ laser method can be used, and when the through hole is formed by chemical processing, a chemical including aminosilane, ketones, etc. can be used, and accordingly, at least one of the plurality of insulating layers can be opened.

When the through hole is formed, the inside of the through hole can be filled with a conductive material to form the first through electrode 131 and the second through electrode 132. The metal material forming the first through electrode 131 and the second through electrode 132 may be any one material selected from among copper (Cu), silver (Ag), tin (Sn), gold (Au), nickel (Ni), and palladium (Pd), and the conductive material filling may utilize any one of electroless plating, electrolytic plating, screen printing, sputtering, evaporation, ink-jetting, and dispensing, or a combination thereof.

The circuit board may include a first protective layer 141 and a second protective layer 142. The first protective layer 141 and the second protective layer 142 may be disposed at an outermost side of the circuit board. For example, the first protective layer 141 may be disposed on a first outermost or a lowest side of the circuit board. For example, the first protective layer 141 may be disposed on the lower surface of the first insulating layer 111. For example, the second protective layer 142 may be disposed on a second outermost or an uppermost side of the circuit board. For example, the second protective layer 142 may be disposed on the upper surface of the second insulating layer 112. The first protective layer 141 may include at least one opening (not shown). For example, the first protective layer 141 may include an opening that vertically overlaps at least one of the third circuit pattern layers 123. For example, the first protective layer 141 may include an opening that vertically overlaps with a terminal electrode pad (not shown) of the third circuit pattern layer 123 on which a conductive bonding portion for connection with an external circuit board is to be disposed. The second protective layer 142 may include at least one opening (not shown). For example, the second protective layer 142 may include an opening that vertically overlaps with at least one of the second circuit pattern layers 122. For example, the second protective layer 142 may include an opening that vertically overlaps with a terminal electrode pad (not shown) of the second circuit pattern layer 122 on which a conductive bonding portion for connection with a memory circuit board or an interposer circuit board is to be disposed. In addition, the second protective layer 142 may include a through hole (not shown) that vertically overlaps with a cavity 121 of the second insulating layer 112. The first protective layer 141 and the second protective layer 142 may include an insulating material. The first protective layer 141 and the second protective layer 142 may include various materials that can be applied and then cured by heating to protect surfaces of the insulating layers and surfaces of the circuit pattern layers. The first protective layer 141 and the second protective layer 142 may be resist layers. For example, the first protective layer 141 and the second protective layer 142 may be solder resist layers including an organic polymer material. As an example, the first protective layer 141 and the second protective layer 142 may include an epoxy acrylate series resin. In detail, the first protective layer 141 and the second protective layer 142 may include a resin, a curing agent, a photoinitiator, a pigment, a solvent, a filler, an additive, an acrylic series monomer, etc. However, the embodiment is not limited thereto, and the first protective layer 141 and the second protective layer 142 may be any one of a photo solder resist layer, a cover-lay, and a polymer material.

A surface treatment layer (not shown) may be disposed in an opening of the first protective layer 141 and the second protective layer 142 that vertically overlaps the second circuit pattern layer 122 and the third circuit pattern layer 123. The surface treatment layer may be formed to prevent corrosion and oxidation of the surface of the third circuit pattern layer 123 that vertically overlaps the opening of the first protective layer 141 and the second circuit pattern layer 122 that vertically overlaps the opening of the second protective layer 142 while improving the soldering characteristics. The surface treatment layer may be an OSP (Organic Solderability Preservative) layer. For example, the surface treatment layer may be an organic layer formed of an organic material such as benzimidazole. However, the embodiment is not limited thereto. For example, the surface treatment layer may be a plating layer. For example, the surface treatment layer may include at least one of a nickel (Ni) plating layer, a palladium (Pd) plating layer, and a gold (Au) plating layer.

The first electrode pad 121-1, the second electrode pad 121-2, and the dummy electrode 121-2 of the first circuit pattern layer 121 may have a same layer structure.

According to the embodiment of FIG. 4, the first circuit pattern layer 121 includes a plurality of metal layers. The first circuit pattern layer 121 includes a first metal layer 121a disposed on the first insulating layer 111. The first metal layer 121a may mean a seed layer for electroplating a second metal layer 121b of the first circuit pattern layer 121. For example, the first metal layer 121a may be a chemical copper plating layer. For example, the first metal layer 121a may be a copper foil layer (Cu foil). In one embodiment, the first metal layer 121a may include only one of a chemical copper plating layer and a copper foil layer. In another embodiment, the first metal layer 121a may include both a chemical copper plating layer and a copper foil layer. A thickness of the first metal layer 121a may satisfy a range of 1.0 µm to 4.0 µm. Preferably, the thickness of the first metal layer 121a may satisfy a range of 1.2 µm to 3.5 µm. More preferably, the thickness of the first metal layer 121a may satisfy a range of 1.5 µm to 3.0 µm. If the thickness of the first metal layer 121a is less than 1.0 µm, the first metal layer 121a may not function as a seed layer. If the thickness of the first metal layer 121a is less than 1.0 µm, it may be difficult to form a first metal layer 121a having a uniform thickness on the upper surface of the first insulating layer 111. If the thickness of the first metal layer 121a exceeds 4.0 µm, a time required to etch the first metal layer 121a may increase. If the thickness of the first metal layer 121a exceeds 4.0 µm, deformation of the second metal layer 121b may occur during etching of the first metal layer 121a. The deformation of the second metal layer 121b may mean that a difference between a width of the upper surface and a width of the lower surface of the second metal layer 121b increases as a side portion of the first metal layer 121a is also etched.

The second metal layer 121b is disposed on the first metal layer 121a. The second metal layer 121b may be an electroplated layer in which the first metal layer 121a is electroplated as a seed layer. A thickness of the second metal layer 121b may correspond to a value obtained by subtracting a thickness of the first metal layer 121a from a total thickness of the first circuit pattern layer 121. Since the total thickness of the first circuit pattern layer 121 has already been described above, a detailed description thereof will be omitted. Meanwhile, each of the first electrode pad 121-1, the second electrode pad 121-2, and the dummy electrode 121-2 of the first circuit pattern layer 121 includes a first metal layer 121a and a second metal layer 121b. At this time, the first electrode pad 121-1, the second electrode pad 121-2, and the dummy electrode 121-2 mean circuit patterns including a same first metal layer 121a and a same second metal layer 121b, and may be distinguished according to an arrangement position and/or function.

According to the embodiment of FIG. 5, the dummy electrode 121-2 may have a thickness different from the thickness of at least one of the first electrode pad 121-1 and the second electrode pad 121-2. For example, the dummy electrode 121-2 may have a different layer structure from at least one of the first electrode pad 121-1 and the second electrode pad 121-2. For example, each of the first electrode pad 121-1 and the second electrode pad 121-2 may include a first metal layer 121a and a second metal layer 121b. Differently, the dummy electrode 121-2 may include only the first metal layer 121a. This means that the second metal layer 121b may not be formed in a portion corresponding to the dummy electrode 121-2 in a process of forming the first circuit pattern layer 121. Thus, unlike the first electrode pad 121-1 and the second electrode pad 121-2, the dummy electrode 121-2 may include only the first metal layer 121a. Through this, the embodiment can reduce a process time for manufacturing the first circuit pattern layer 121. Furthermore, the embodiment can reduce the cost or materials required for manufacturing the circuit board.

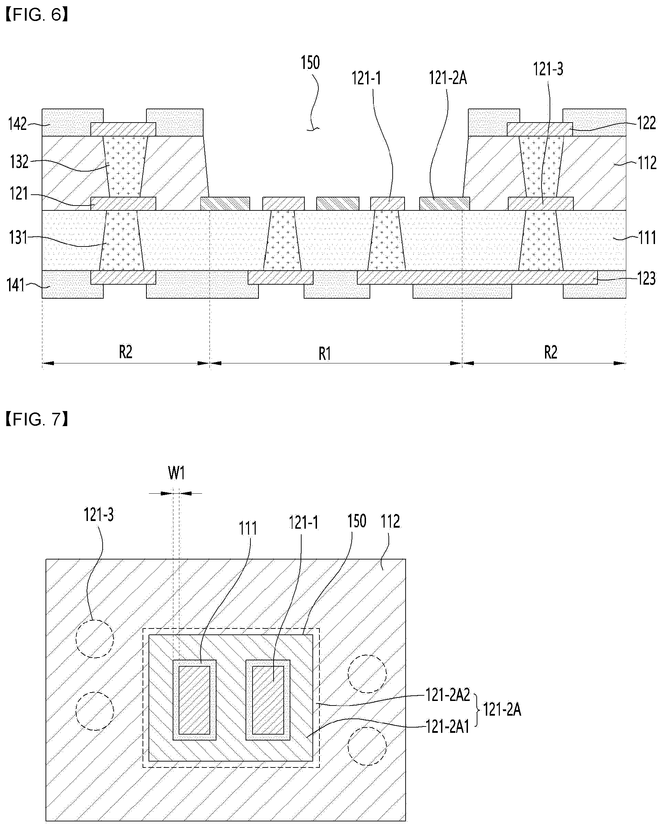

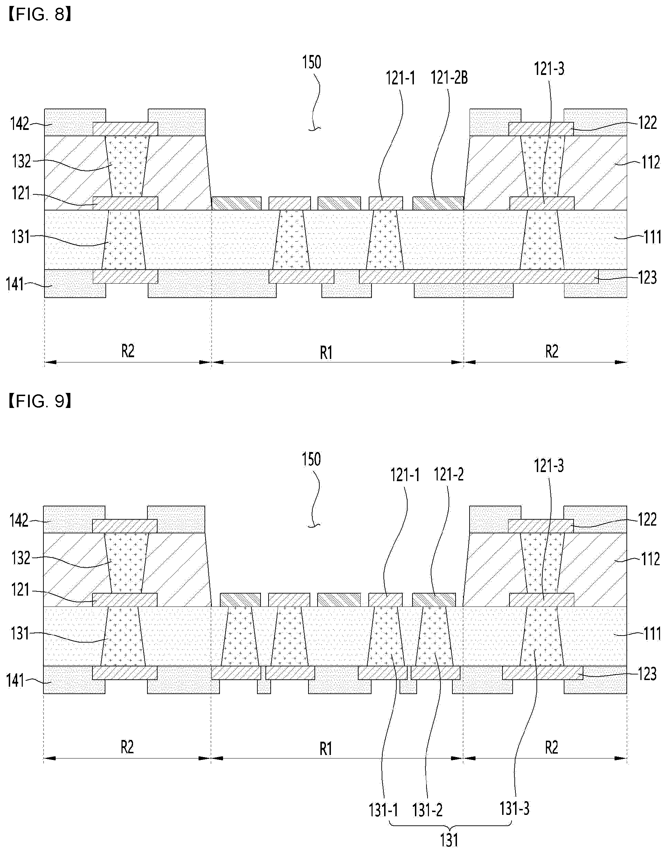

FIG. 6 is a cross-sectional view illustrating a first modified example of the circuit board of FIG. 2, FIG. 7 is a plan view in which some components are removed from the circuit board of FIG. 6, and FIG. 8 is a cross-sectional view illustrating a second modified example of the circuit board of FIG. 2.

Referring to FIGS. 6 and 7, the circuit board of a first modified example may differ from the circuit board of the first embodiment in an arrangement position of the dummy electrode.

Specifically, the circuit board of the first modified example may include a dummy electrode 121-2A disposed on the first insulating layer 111. The dummy electrode 121-2A may include a portion that contacts the second insulating layer 112.

For example, at least a portion of the dummy electrode 121-2A disposed in an edge region of the lower surface of the cavity 150 may be in contact with the second insulating layer 112. For example, the dummy electrode 121-2A may include a portion extending from a portion disposed in the first region R1 and disposed in the second region R2. Accordingly, at least a portion of an upper surface of the dummy electrode 121-2A may be covered by the second insulating layer 112. Specifically, the dummy electrode 121-2A may include a first portion 121-2A1 disposed in the first region R1 and having an upper surface exposed through the cavity 150. In addition, the dummy electrode 121-2A may include a second portion 121-2A2 disposed in the second region R2 and having an upper surface covered with the second insulating layer 112. In addition, the first portion 121-2A1 and the second portion 121-2A2 of the dummy electrode 121-2A can be connected to each other.

Accordingly, the embodiment can allow least a part of the dummy electrode 121-2A to be covered by the second insulating layer 112. Through this, a separation region between the dummy electrode 121-2A and the side wall of the cavity 150 may not exist. Therefore, the embodiment can prevent the etching solution according to the de-smear process from penetrating into the separation region between the side wall of the cavity 150 and the dummy electrode 121-2A.

Referring to FIG. 8, the circuit board of a second modified example may be different from the circuit board of the first modified example in an arrangement position of the dummy electrode. Specifically, the circuit board of the second modified example may include a dummy electrode 121-2B disposed on the first insulating layer 111. The dummy electrode 121-2B may include a portion in contact with the second insulating layer 112. For example, at least a portion of the dummy electrode 121-2B disposed in the edge region of the lower surface of the cavity 150 may be in contact with the second insulating layer 112. For example, the dummy electrode 121-2B may be disposed only in the first region R1. At this time, an edge of the dummy electrode 121-2B may correspond to the side wall of the cavity 150. For example, an edge side surface of the dummy electrode 121-2B may be covered with the second insulating layer 112 having the cavity 150.

That is, the first modified example may have a structure in which at least a part of the dummy electrode 121-2A is disposed in the second region R2, and thereby a part of the upper surface of the dummy electrode 121-2A is covered with the second insulating layer 112. In addition, the second modified example may have a structure in which only a part of the side surface of the dummy electrode 121-2B is covered with the second insulating layer 112 while the dummy electrode 121-2B is disposed only in the first region R1.

FIG. 9 is a cross-sectional view showing a circuit board according to a second embodiment.

Referring to FIG. 9, the circuit board of the second embodiment may have a different structure of the first through electrode 131 compared to the circuit board of the first embodiment.

The first through electrode 131 of the circuit board of the first embodiment may be connected to the first electrode pad 121-1 and the second electrode pad 121-2, and may not be connected to the dummy electrode 121-2. The circuit board of the second embodiment may include a plurality of through parts depending on a location.

For example, the first through electrode 131 may include a first through part 131-1 vertically overlapping the first region R1. The first through part 131-1 may vertically overlap the first electrode pad 121-1. For example, the first through part 131-1 may be a signal through electrode electrically connected to the first electrode pad 121-1.

In addition, the first through electrode 131 may include a second through part 131-2 vertically overlapping the first region R1 and horizontally spaced from the first through part 131-1. The second through part 131-2 may vertically overlap the dummy electrode 121-2. For example, the second through part 131-2 may be a dummy through electrode connected to the dummy electrode 121-2. At this time, the second through part 131-2 may be provided in multiple numbers. For example, the second through part 131-2 may include a plurality of through parts horizontally spaced apart and commonly connected to one dummy electrode 121-2.

At this time, the dummy electrode 121-2 and the second through part 131-2 may have a function of improving the heat dissipation characteristics of the circuit board. For example, the dummy electrode 121-2 and the second through part 131-2 may transfer heat generated from a connection member disposed in the cavity 150 to the outside of the circuit board. Through this, the embodiment may improve the heat dissipation characteristics of the circuit board and the semiconductor package including the same. Therefore, the embodiment may improve the product reliability of the circuit board and the semiconductor package including the same.

In addition, the first through electrode 131 may include a third through part 131-3 vertically overlapping the second region R2. The third through part 131-3 may be vertically overlapped with the second electrode pad 121-2. The third through part 131-3 may be electrically connected to the second electrode pad 121-2.

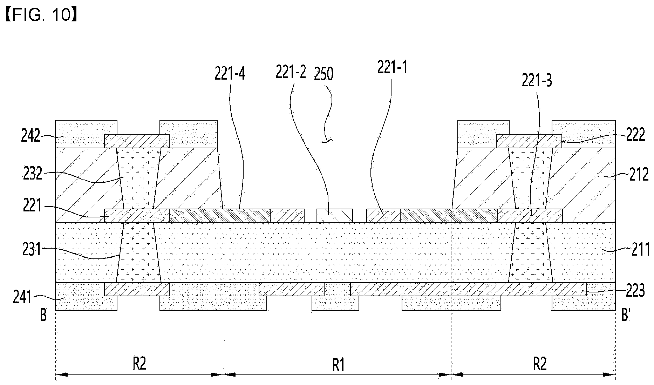

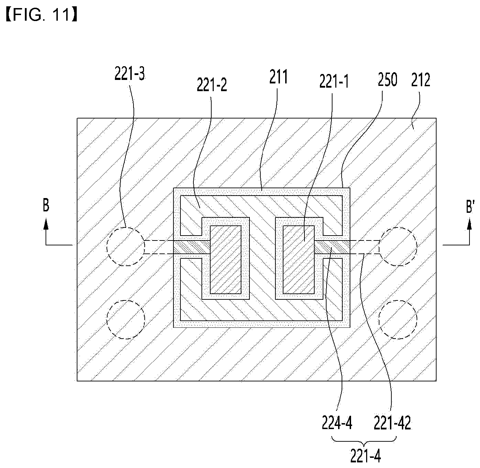

FIG. 10 is a cross-sectional view illustrating a circuit board according to a third embodiment, and FIG. 11 is a plan view in which some components are removed from the circuit board of FIG. 10.

Referring to FIGS. 10 and 11, a circuit board of a third embodiment may differ have a different structure of the first circuit pattern layer 121 compared to the circuit board of the first embodiment.

The circuit board of the third embodiment may include a first insulating layer 211, a second insulating layer 212, a first circuit pattern layer 221, a second circuit pattern layer 222, a third circuit pattern layer 223, a first through electrode 231, a second through electrode 232, a first protective layer 241, and a second protective layer 242.

The first insulating layer 211, the second insulating layer 212, the second circuit pattern layer 222, the third circuit pattern layer 223, the first through electrode 231, the second through electrode 232, the first protective layer 241, and the second protective layer 242 have a same structure as a corresponding configuration of the circuit board of the first embodiment, and a detailed description thereof will be omitted.

The first circuit pattern layer 221 may include a first electrode pad 221-1 disposed on the first region R1. In addition, the first circuit pattern layer 221 may include a second electrode pad 221-3 disposed on the second region R2.

In addition, the first circuit pattern layer 221 may include a dummy electrode 221-2 disposed on the first region R1 and electrically and physically separated from the first electrode pad 221-1.

Meanwhile, the first electrode pad and the second electrode pad in the first embodiment have a structure in which the first electrode pad and the second electrode pad are not directly connected to each other by the first circuit pattern layer.

Differently, the first electrode pad 221-1 and the second electrode pad 221-3 of the first circuit pattern layer 221 of the third embodiment may have a structure in which the first electrode pad 221-1 and the second electrode pad 221-3 are directly connected to each other by the first circuit pattern layer 221.

Specifically, the first electrode pad 221-1 and the second electrode pad 221-3 can exchange electrical signals with each other on the first insulating layer 111 without being connected to the first through electrode 231.

To this end, the first circuit pattern layer 221 may include a connection pattern 221-4.

The connection pattern 221-4 may be disposed on the first region R1 and the second region R2 of the first insulating layer 211. At this time, the first circuit pattern layer 221 may include a plurality of connection patterns, and the connection pattern 221-4 described below may mean a connection pattern connecting the first electrode pad 221-1 and the second electrode pad 221-3 among the plurality of connection patterns.

The connection pattern 221-4 can directly connect between the first electrode pad 221-1 disposed on the first region R1 and the second electrode pad 221-3 disposed on the second region R2. Through this, the embodiment can reduce a signal transmission distance between the first electrode pad 221-1 and the second electrode pad 221-3. Therefore, the embodiment can minimize signal transmission loss and further improve the electrical characteristics of the circuit board and the semiconductor package including the same.

The connection pattern 221-4 can include a first portion 221-41 disposed on the first region R1 and connected to the first electrode pad 221-1. In addition, the connection pattern 221-4 can include a second portion 221-42 disposed on the second region R2 and connected to the second electrode pad 221-3. In addition, the first portion 221-41 and the second portion 221-42 of the connection pattern 221-4 can be directly connected to each other. Therefore, the first electrode pad 221-1 and the second electrode pad 221-3 can directly exchange electrical signals with each other using the connection pattern 221-4 without going through the first through electrode 231. Through this, the embodiment can improve the circuit integration of the circuit board by arranging the connection pattern 221-4 on the first region R1 of the first insulating layer 211.

The connection pattern 221-4 may be physically separated from the dummy electrode 221-2 while making contact with the first electrode pad 221-1 on the first region R1. Furthermore, the first circuit pattern part occupying a range of 50% to 90%, a range of 55% to 85%, or a range of 60% to 85% of the total area of the first region R1 in the first embodiment may include the first electrode pad 121-1 and the dummy electrode 121-2. In addition, the first circuit pattern part occupying a range of 50% to 90%, a range of 55% to 85%, or a range of 60% to 85% of the total area of the first region R1 in the third embodiment may include the first electrode pad 221-1, the dummy electrode 221-2, and the connection pattern 221-4.

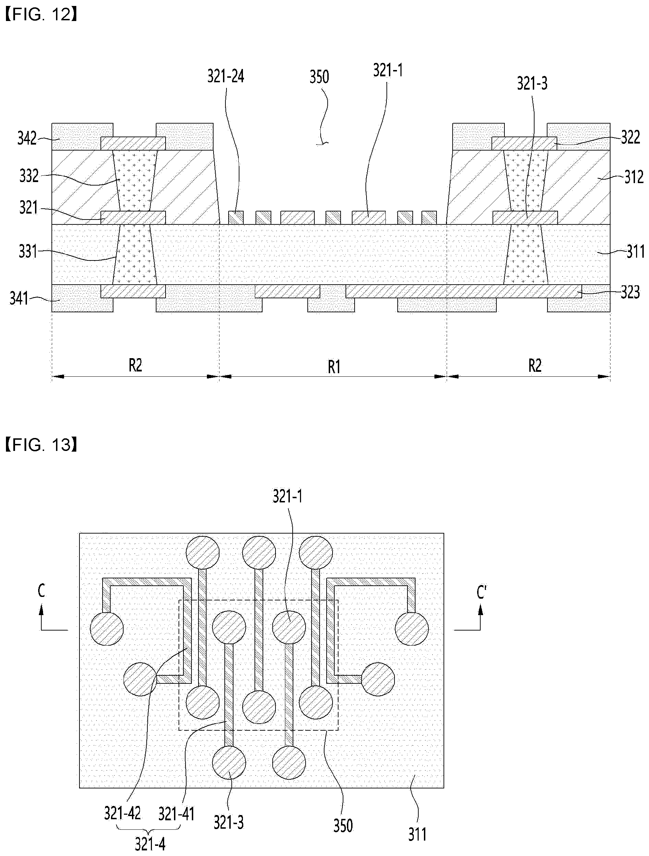

FIG. 12 is a cross-sectional view illustrating a circuit board according to a fourth embodiment, and FIG. 13 is a plan view in which some components are removed from the circuit board of FIG. 12.

Referring to FIGS. 12 and 13, the circuit board of the fourth embodiment may have a different structure of the first circuit pattern layer compared to the circuit board of the third embodiment.

The circuit board of the fourth embodiment may include a first insulating layer 311, a second insulating layer 312, a first circuit pattern layer 321, a second circuit pattern layer 322, a third circuit pattern layer 323, a first through electrode 331, a second through electrode 332, a first protective layer 341, and a second protective layer 342.

The first insulating layer 311, the second insulating layer 312, the second circuit pattern layer 322, the third circuit pattern layer 323, the first through electrode 331, the second through electrode 332, the first protective layer 341, and the second protective layer 342 have a same structure as a corresponding configuration of the circuit board of the third embodiment, and a detailed description thereof will be omitted.

The first circuit pattern layer 321 may include a first electrode pad 321-1 disposed on the first region R1. In addition, the second circuit pattern layer 321 may include a second electrode pad 321-3 disposed on the second region R2. In addition, the first circuit pattern layer 321 may include a connection pattern 321-4 disposed on the first region R1. In addition, compared to the third embodiment, the first circuit pattern layer 321 of the circuit board of the fourth embodiment may not include a dummy electrode. That is, the circuit boards of the first and second embodiments include a first circuit pattern part including a first electrode pad and a dummy electrode, and the arrangement of the dummy electrode can protect the upper surface of the first insulating layer in the de-smear process.

In addition, the circuit board of the third embodiment includes a first circuit pattern part including a first electrode pad, a dummy electrode, and a connection pattern, and the arrangement of the connection pattern and the dummy electrode can protect the upper surface of the first insulating layer while directly connecting the first electrode pad and the second electrode pad.

In addition, the circuit board of the fourth embodiment may include a first circuit pattern part including a first electrode pad 321-1 and a connection pattern 321-4. The fourth embodiment can directly connect the first electrode pad 321-1 and the second electrode pad 321-3 while protecting the upper surface of the first region R1 of the first insulating layer 311 by using the connection pattern 321-4 without arranging the dummy electrode.

Therefore, the first circuit pattern part occupying a range of 50% to 90%, a range of 55% to 85%, or a range of 60% to 85% of the total area of the first region R1 in the fourth embodiment can include the first electrode pad 321-1 and the connection pattern 321-4. At this time, when only the connection pattern directly connecting the first electrode pad 321-1 and the second electrode pad 321-3 is disposed, the first circuit pattern part may not occupy an area of more than 50% of the total area of the first region R1. Accordingly, a connection pattern other than the connection pattern connecting the first electrode pad 321-1 and the second electrode pad 321-3 may also be disposed on the first region R1.

Specifically, referring to FIG. 13, the connection pattern 321-4 may include a first connection pattern 321-41 disposed on the first region R1 and the second region R2 to connect the first electrode pad 321-1 and the second electrode pad 321-3. In addition, the connection pattern 321-4 may include a second connection pattern 321-42 disposed on the first region R1 and the second region R2 to connect between a plurality of second electrode pads. That is, the second connection pattern 321-42 connects between a plurality of second electrode pads disposed on the second region R2. At this time, conventionally, the connection pattern connecting between the plurality of second electrode pads was not disposed on the first region R1 vertically overlapping the cavity. That is, conventionally, the second insulating layer having the cavity contains a thermosetting material rather than a photocurable material such as PID, and therefore, there is no need to form a fine pattern within the cavity, so even if the glass fiber of the first insulating layer is partially exposed as the de-smear process is performed, it does not have a significant effect on reliability.

Differently, the embodiment may have a second connection pattern 321-42 connecting between the plurality of second electrode pads. In addition, the second connection pattern 321-42 may electrically connect between the plurality of second electrode pads via the first region R1. Through this, the embodiment may further improve the circuit integration of the circuit board and the semiconductor package.

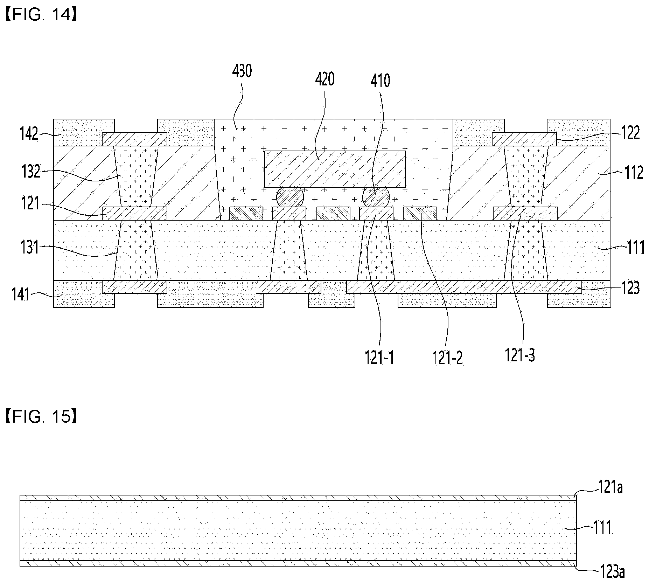

FIG. 14 is a view illustrating a semiconductor package including the circuit board of FIG. 2.

Referring to FIG. 14, a package circuit board may include a connecting member 410 disposed on the first electrode pad 121-1, and a connection member 420 disposed on the connecting member 410. The connection member may be any one of the second circuit board, the semiconductor device, and the connection member described in FIGS. 1a to 1g.

A molding member 430 may be disposed in the cavity 150. The molding member 430 may be disposed by molding the connection member 420 within the cavity 150. Furthermore, the molding member 430 may mold the dummy electrode 121-2. At this time, the molding member 430 is connected to the dummy electrode 121-2, and thus may dissipated heat transmitted through the dummy electrode 121-2 to the outside. In addition, the molding member 430 may have a low dielectric constant in order to enhance heat dissipation characteristics. For example, the dielectric constant (Dk) of the molding member 430 may be 0.2 to 10. For example, the dielectric constant (Dk) of the molding member 430 may be 0.5 to 8. For example, the dielectric constant (Dk) of the molding member 430 may be 0.8 to 5. Accordingly, in the embodiment, the molding member 430 has a low dielectric constant, thereby improving the heat dissipation characteristics of the connection member.

FIGS. 15 to 20 are views showing a method of manufacturing the circuit board of FIG. 2 according to an embodiment in order of processes.

Referring to FIG. 15, the embodiment prepares an insulating member that is the basis for manufacturing the circuit board. For example, the embodiment includes an insulating member including a first insulating layer 111 and a metal layer disposed on the first insulating layer 111. The metal layer may include a metal layer 121a disposed on the first insulating layer 111 and a metal layer 123a disposed under the first insulating layer 111. In addition, the metal layer 121a may be used as a seed layer for forming the first circuit pattern layer 121 by electrolytic plating. In addition, the metal layer 123a may be used as a seed layer for forming the third circuit pattern layer 123 by electrolytic plating.

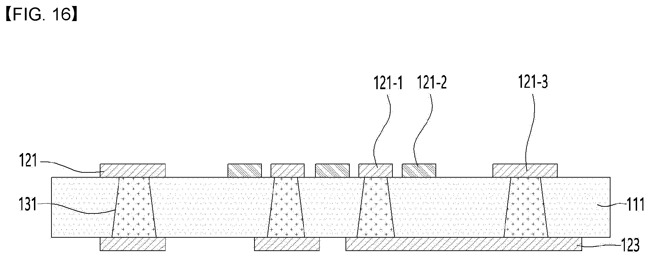

Next, referring to FIG. 16, the embodiment may perform electrolytic plating using a metal layer 121a and 123a as a seed layer to form a second metal layer of the first circuit pattern layer 121, a second metal layer of the third circuit pattern layer 123, and a first through electrode 131 passing through the first insulating layer 111. At this time, the first circuit pattern layer 121 in one embodiment may include a first electrode pad, a second electrode pad, and a dummy electrode. The first circuit pattern layer 121 in another embodiment may include a first electrode pad, a second electrode pad, a dummy electrode, and a connection pattern. The first circuit pattern layer 121 in another embodiment may include a first electrode pad, a second electrode pad, and a connection pattern.

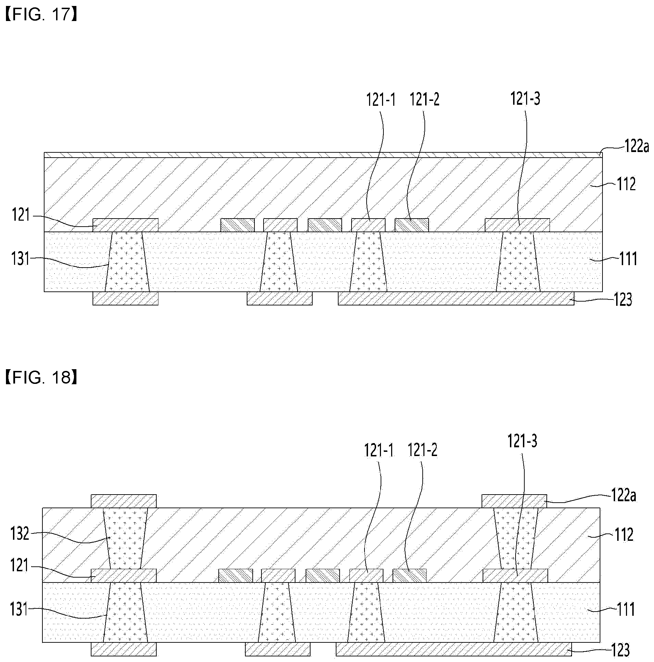

Next, referring to FIG. 17, the embodiment may dispose a second insulating layer 112 on the first insulating layer 111. At this time, the first metal layer 122a of the second circuit pattern layer 122, which is the seed layer of the second circuit pattern layer 122, may be disposed on the upper surface of the second insulating layer 112.

Next, referring to FIG. 18, the embodiment may perform electrolytic plating using the first metal layer 122a of the second circuit pattern layer 122 as a seed layer to form the second metal layer 122b of the second circuit pattern layer 122. At this time, the second through electrode 132 passing through the second insulating layer 112 together with the second metal layer 122b may be formed. At this time, a process of forming the second through electrode 132 and a process of forming the cavity 150 are depicted as being separate processes in the drawing. However, the embodiment is not limited thereto. For example, the cavity 150 may be formed together with the through hole in a process of forming the through hole for the second through electrode 132.

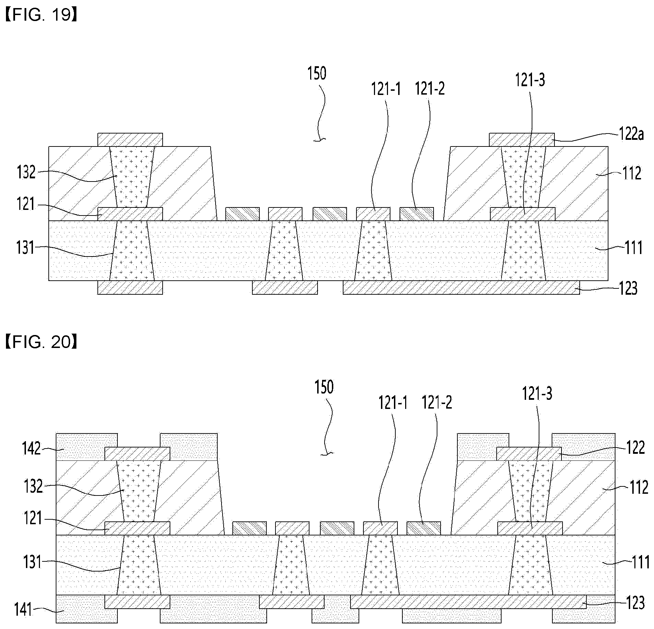

Next, referring to FIG. 19, the embodiment may proceed with a process of forming the cavity 150 by exposing and developing the first region R1 of the first insulating layer 112.

Next, referring to FIG. 20, the embodiment may perform a process of forming the first protective layer 141 under the first insulating layer 111 and forming the second protective layer 142 on the second insulating layer 112.

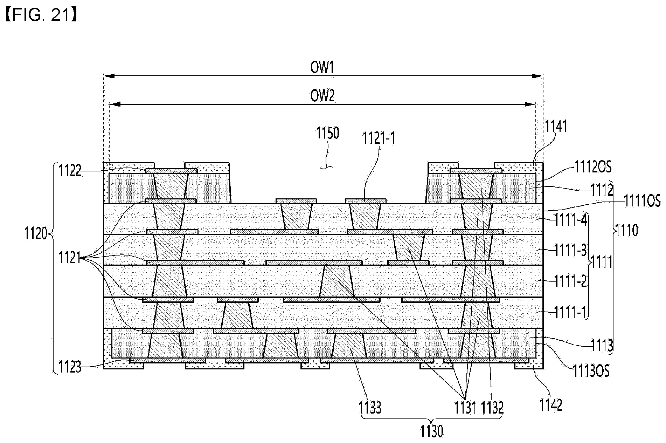

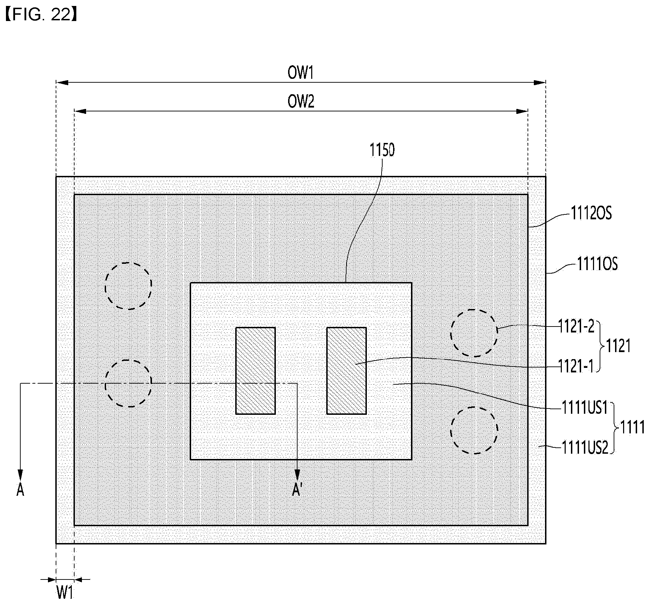

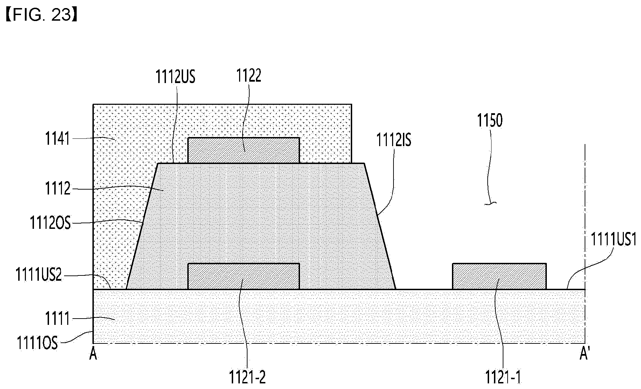

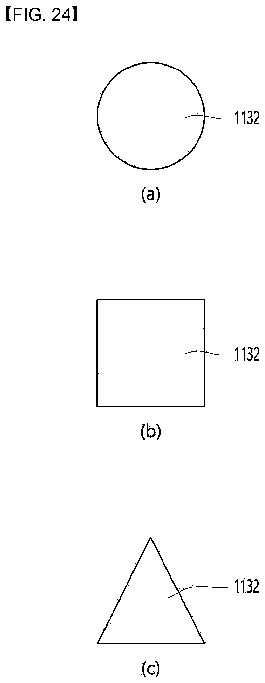

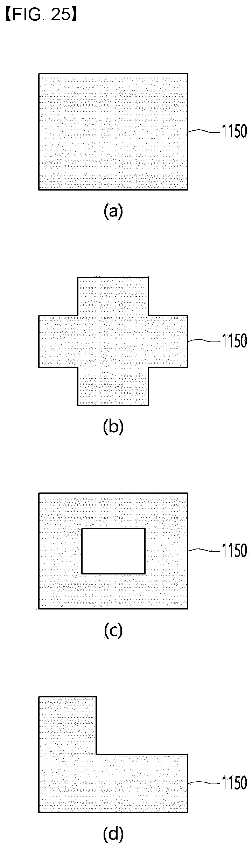

FIG. 21 is a cross-sectional view illustrating a circuit board of a fifth embodiment, FIG. 22 is a plan view in which some components are removed from the circuit board of FIG. 21, FIG. 23 is a cross-sectional view taken along a direction A-A' of FIG. 21 according to an embodiment, FIG. 24 is a view showing a planar shape of a second through electrode of FIG. 21, and FIG. 25 is a view illustrating a planar shape of a cavity of FIG. 21. Hereinafter, the circuit board of the fifth embodiment will be described with reference to FIGS. 21 to 25, but detailed descriptions of configurations components identical to or corresponding to those of the circuit board illustrated in FIGS. 2 to 13 will be omitted.

The circuit board includes an insulating layer 1110, and the insulating layer 1110 may include a first insulating layer 1111, a second insulating layer 1112, and a third insulating layer 1113. For example, the circuit board illustrated in FIGS. 2 to 13 may further include a third insulating layer 1113.

The first insulating layer 1111 may include a first layer 1111-1, a second layer 1111-2, a third layer 1111-3, and a fourth layer 1111-4, but the embodiment is not limited thereto, and a number of layers of the first insulating layer 1111 may vary according to an embodiment. The second insulating layer 1112 may be disposed on the first insulating layer 1111. The second insulating layer 1112 may include a cavity 1150. In addition, when the second insulating layer 1112 is provided with a plurality of layers, the cavity 1150 may passes through a plurality of layers of the second insulating layer. The third insulating layer 1113 may be disposed under the first insulating layer 1111. Each of the second insulating layer 1112 and the third insulating layer 1113 may be provided in multiple layers, but for convenience of explanation, each of the second insulating layer 1112 and the third insulating layer 1113 will be described below as being provided in a single layer. At this time, when the first insulating layer 1111 has a multiple layer structure, an upper surface of the first insulating layer 1111 described below may mean an upper surface of an uppermost layer of the first insulating layer 1111, and a lower surface of the first insulating layer 1111 may mean a lower surface of a lowermost layer of the first insulating layer 1111. The first insulating layer 1111, the second insulating layer 1112, and the third insulating layer 1113 may include different insulating materials. For example, the first insulating layer 1111 may include a thermosetting resin. In addition, the second insulating layer 1112 and the third insulating layer 1113 may include a photocurable resin.

Referring to FIGS. 22 and 23, the second insulating layer 1112 may include a cavity 1150. The cavity 1150 may passes through upper and lower surfaces of the second insulating layer 1112. The cavity 1150 may include a lower surface 1111US1 and a side wall 1112IS. Since the cavity 1150 has been described with reference to FIGS. 2 to 13, a detailed description thereof will be omitted.

The cavity 1150 may be formed by exposing and developing the second insulating layer 1112 including the photocurable resin. Therefore, a planar shape of the cavity 1150 may have various shapes. For example, referring to (a) of FIG. 25, a planar shape of the cavity 1150 may have a square shape. For example, referring to (b) of FIG. 25, a planar shape of the cavity 1150 may have a plus (+) shape. For example, referring to (c) of FIG. 25, a planar shape of the cavity 1150 may have a square shape with an unopened central region. For example, referring to (d) of FIG. 25, a planar shape of the cavity 1150 may have an "L" shape.

An upper surface of the first insulating layer 1111 may be divided into a plurality of regions. For example, the first insulating layer 1111 may include a first region that vertically overlaps the cavity 1150. At this time, when a width of the cavity 1150 changes in the thickness direction of the second insulating layer 1112, the first region may mean a region that vertically overlaps with a lower region of the cavity 1150 corresponding to a lower end of the side wall 1112IS. In addition, the first insulating layer 1111 may include a second region that does not vertically overlap with the cavity 1150. The second region may mean a region that is covered with the second insulating layer 1112 among the upper surfaces of the first insulating layer 1111. In addition, the first insulating layer 1111 may include a third region that does not vertically overlap with the cavity 1150 and does not come into contact with the second insulating layer 1112. The third region may correspond to an edge region of the first insulating layer 1111. For example, the third region may correspond to an outer region of an upper surface of the first insulating layer 1111 adjacent to a side surface of the first insulating layer 1111. In addition, the second insulating layer 1112 may not be disposed in the third region of the first insulating layer 1111. An outer width OW1 of the first insulating layer 1111 may be different from an outer width OW2 of the second insulating layer 1112. Preferably, the outer width OW1 of the first insulating layer 1111 may be larger than the outer width OW2 of the second insulating layer 1112. Here, the outer width may mean a width and/or distance in a horizontal direction of two outer side surfaces of each insulating layer facing each other.

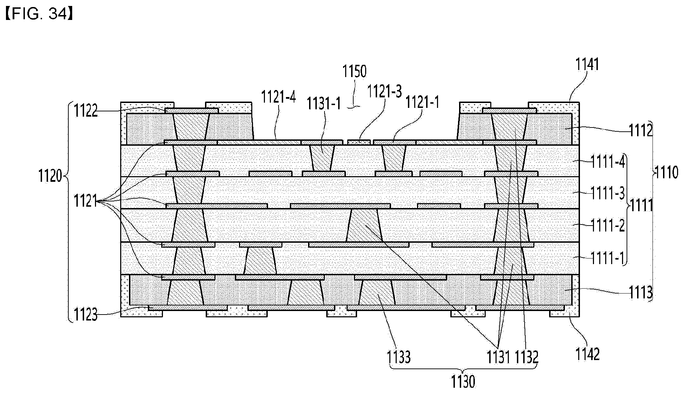

An outer side surface 111OS of the first insulating layer 1111 may be positioned further outside than an outer side surface 112OS of the second insulating layer 1112. An outer side surface 1120S of the second insulating layer 1112 may be positioned further inside than an outer side surface 111OS of the first insulating layer 1111. The second insulating layer 1112 may include an open region that vertically overlaps the third region of the first insulating layer 1111. Accordingly, the open region of the second insulating layer 1112 may be connected to the outer side surface 1120S of the second insulating layer 1112. Accordingly, the outer width OW2 of the second insulating layer 1112 may be smaller than the outer width OW1 of the first insulating layer 1111 by a width of the open region. For example, the outer width OW1 of the first insulating layer 1111 may be as large as the width of the open region compared to the outer width OW2 of the second insulating layer 1112. The open region may mean a second through hole VH2 illustrated in FIG. 34. The open region of the second insulating layer 1112 may be formed together with the through hole corresponding to the second through electrode 1132 and the cavity 1150. For example, the open region of the second insulating layer 1112 may be formed together with the through hole and the cavity 1150 through an exposure and development process. Therefore, the outer side surface 1120S of the second insulating layer 1112 may have a slope. For example, the outer side surface 1120S of the second insulating layer 1112 may be inclined with a certain slope from the upper surface of the second insulating layer 1112 toward the lower surface of the second insulating layer 1112. For example, a horizontal distance between the outer side surface 112OS of the second insulating layer 1112 and the outer side surface 111OS of the first insulating layer 1111 may have different distances in the vertical direction.

The outer side surface 1120S of the second insulating layer 1112 may have a slope in which the horizontal distance becomes smaller as it approaches the outer side surface 111OS of the first insulating layer 1111. However, the embodiment is not limited thereto. For example, the outer side surface 112OS of the second insulating layer 1112 may have a slope in which the horizontal distance becomes larger as it approaches the outer side surface 111OS of the first insulating layer 1111. The outer side surface 1120S of the second insulating layer 1112 may have a slope in which the outer width OW2 of the second insulating layer 1112 changes from the upper surface of the second insulating layer 1111 toward the lower surface of the second insulating layer 1112. For example, the outer side surface 112OS of the second insulating layer 1112 may have a slope in which the outer width OW2 of the second insulating layer 1112 increases from the upper surface of the second insulating layer 1111 toward the lower surface of the second insulating layer 1112. However, the embodiment is not limited thereto. For example, the outer side surface 1120S of the second insulating layer 1112 may have a slope in which the outer width OW2 of the second insulating layer 1112 decreases from the upper surface of the second insulating layer 1111 toward the lower surface of the second insulating layer 1112.

Accordingly, the outer side surface 111OS of the first insulating layer 1111 and the outer side surface 112OS of the second insulating layer 1112 may have a step in the horizontal direction. For example, the step may mean a horizontal distance W1 between the outer side surface 111OS of the first insulating layer 1111 and the outer side surface 112OS of the second insulating layer 1112. The horizontal distance W1 may satisfy a range of 2 µm to 30 µm. For example, the horizontal distance W1 may satisfy a range of 3 µm to 28 µm. For example, the horizontal distance W1 may satisfy a range of 5 µm to 25 µm. If the horizontal distance W1 is less than 2 µm, an effect of improving the adhesion between the first insulating layer 1111 and the second insulating layer 1112 according to the embodiment may be insignificant. Due to this, if it is separated from the second insulating layer 1112 and goes up on a first electrode pad part during a process of mounting the semiconductor device, a poor contact may occur during the mounting of the semiconductor device. In addition, if the horizontal distance W1 exceeds 30 µm, the circuit integration may be reduced. For example, if the horizontal distance W1 exceeds 30 µm, it may mean that the second circuit pattern layer 1122 is not disposed in a region corresponding to the horizontal distance W1 of the second insulating layer 1112 in the entire region of the circuit board. Accordingly, the circuit integration may be reduced as the region where the second circuit pattern layer 1122 is not disposed increases. Through this, the embodiment can improve the adhesion of the insulating layer 1110 of the circuit board.

For example, the first insulating layer 1111 and the second insulating layer 1112 may include different insulating materials. In addition, the second insulating layer 1112 may include a photocurable resin, unlike the first insulating layer 1111. As a result, the adhesion between the first insulating layer 1111 and the second insulating layer 1112 may be reduced. Furthermore, the first insulating layer 1111 and the second insulating layer 1112 may have different thermal expansion coefficients. Therefore, a problem in which the circuit board is greatly warped in a specific direction may occur due to the difference in the thermal expansion coefficients between the first insulating layer 1111 and the second insulating layer 1112. At this time, the embodiment allows the outer width OW2 of the second insulating layer 1112 to be smaller than the outer width OW1 of the first insulating layer 1111. Therefore, the embodiment can prevent the circuit board from being warped in a specific direction by the second insulating layer 1112. Through this, the embodiment can improve the physical reliability and electrical reliability of the circuit board. Furthermore, in the embodiment, a first protective layer 1141 may be disposed on the second insulating layer 1112 to surround the upper surface and the outer side surface 112OS of the second insulating layer 1112. The first protective layer 1141 may function to protect the circuit pattern layer disposed on the second insulating layer 1112 while improving the adhesion between the first insulating layer 1111 and the second insulating layer 1112. Through this, the embodiment may improve the adhesion between the first insulating layer 1111 and the second insulating layer 1112. As a result, the embodiment may solve the problem of the second insulating layer 1112 being peeled off from the first insulating layer 1111 or the physical reliability problem of the circuit pattern layer disposed on the second insulating layer 1112 being peeled off from the second insulating layer 1112. A structure of the first protective layer 1141 will be described in more detail below.

The third insulating layer 1113 may be disposed under the first insulating layer 1111. A layer structure of the third insulating layer 1113 may have a symmetrical structure with the layer structure of the second insulating layer 1112 based on the first insulating layer 1111. Through this, the embodiment may solve a problem of warpage of the circuit board caused by the asymmetrical structure, thereby improving the electrical reliability and/or physical reliability of the circuit board and the semiconductor package including the same.

For example, the outer width of the third insulating layer 1113 may be smaller than the outer width OW1 of the first insulating layer 1111. Through this, the outer side surface 113OS of the third insulating layer 1113 and the outer side surface 111OS of the first insulating layer 1111 may have a step.

At this time, in the embodiment of FIG. 21, the outer side surface 113OS of the third insulating layer 1113 and the outer side surface 112OS of the second insulating layer 1112 are shown as being positioned on a same vertical line, but the embodiment is not limited thereto.

For example, the outer side surface 113OS of the third insulating layer 1113 and the outer side surface 1120S of the second insulating layer 1112 may also have a step based on a direction in which the circuit board is bent. For example, when the circuit board is greatly bent in a first vertical direction, the outer side surface 112OS of the second insulating layer 1112 may be positioned further inward than the outer side surface 113OS of the third insulating layer 1113. Conversely, when the circuit board is significantly bent in a second vertical direction opposite to the first vertical direction, the outer side surface 1120S of the second insulating layer 1112 may be positioned further outward than the outer side surface 113OS of the third insulating layer 1113.

A circuit pattern layer 1120 may be disposed on the first insulating layer 1111, the second insulating layer 1112, and the third insulating layer 1113.

For example, a first circuit pattern layer 1121 may be disposed on the first insulating layer 1111. For example, a first circuit pattern layer may be disposed on a lower surface of the first layer 1111-1 of the first insulating layer 1111, between the upper surface of the first layer 1111-1 and the lower surface of the second layer 1111-2, between the upper surface of the second layer 1111-2 and the lower surface of the third layer 1111-3, between the upper surface of the third layer 1111-3 and the lower surface of the fourth layer 1111-4, and on the upper surface of the fourth layer 1111-4.

In addition, a second circuit pattern layer 1122 may be disposed on the second insulating layer 1112. In addition, a third circuit pattern layer 1123 may be disposed under the third insulating layer 1113.

The first circuit pattern layer 1121 may include a plurality of circuit patterns disposed on the upper surface of the first insulating layer 1111. For example, the first circuit pattern layer 1121 may include a plurality of circuit patterns disposed on the fourth layer 1111-4 of the first insulating layer 1111.

The first circuit pattern layer 1121 may include a first electrode pad 1121-1 disposed on the first region of the first insulating layer 1111. The first electrode pad 1121-1 may vertically overlap the cavity 1150. Therefore, the first electrode pad 1121-1 may not be in contact with the second insulating layer 1112. The first circuit pattern layer 1121 may include a second electrode pad 1121-2 disposed on the second region of the first insulating layer 1111. The second electrode pad 1121-2 may not vertically overlap the cavity 1150. Therefore, the second electrode pad 1121-2 may be covered with the second insulating layer 1112.

Referring again to FIG. 21, the circuit board of the embodiment may include a through electrode 1130. The through electrode 1130 may function to electrically connect circuit pattern layers disposed on different layers to each other. The through electrode may also be referred to as a 'via'.

The through electrode can passes through at least one of the first insulating layer 1111, the second insulating layer 1112, and the third insulating layer 1113 included in the circuit board. Accordingly, the through electrode is possible to electrically connect circuit patterns disposed on different layers. At this time, the through electrode 1130 can be formed by passing through only one insulating layer, or differently, it can be formed by passing through at least two or more insulating layers in common.

The first through electrode 1131 can be formed by passing through the first insulating layer 1111. For example, the first through electrode 1131 can pass through at least one of the first layer 1111-1, the second layer 1111-2, the third layer 1111-3, and the fourth layer 1111-4 of the first insulating layer 1111. The first through electrode 1131 can electrically connect the first circuit pattern layers 1121 disposed on different layers of the first insulating layer 1111. The second through electrode 1132 can pass through the second insulating layer 1112. The second through electrode 1132 can electrically connect between the first circuit pattern layer 1121 and the second circuit pattern layer 1122. The third through electrode 1133 can pass through the third insulating layer 1113. The third through electrode 1133 can electrically connect between the first circuit pattern layer 1121 and the third circuit pattern layer 1123.

A through hole passing through the first insulating layer 1111 and a through hole passing through the second insulating layer 1112 and the third insulating layer 1113 can be formed by different methods. For example, the first insulating layer 1111 may include a thermosetting resin. Accordingly, a through hole may be formed in the first insulating layer 1111 through a laser process. For example, the second insulating layer 1112 and the third insulating layer 1113 may include a photocurable resin. A through hole may be formed in the second insulating layer 1112 and the third insulating layer 1113 through an exposure and development process. Accordingly, in one embodiment, a through hole passing through the first insulating layer 1111 and a through hole passing through the second insulating layer 1112 and the third insulating layer 1113 may have different planar shapes. In addition, in another embodiment, a through hole passing through the first insulating layer 1111 and a through hole passing through the second insulating layer 1112 and the third insulating layer 1113 may have a same planar shape. Therefore, according to the embodiment, the first through electrode 1131 may have a same planar shape as the second through electrode 1132 and the third through electrode 1133, or may have a planar shape different from that of the second through electrode 1132 and the third through electrode 1133. For example, the planar shape of the first through electrode 1131 may have a circular shape or an elliptical shape. In addition,, the second through electrode 1132 and the third through electrode 1133 may have various planar shapes.

For example, referring to (a) of FIG. 24, the planar shapes of the second through electrode 1132 and the third through electrode 1133 may have a circular shape or an elliptical shape, which is a same planar shape as a planar shape of the first through electrode 1131. For example, referring to (b) of FIG. 24, the planar shapes of the second through electrode 1132 and the third through electrode 1133 may have a square shape different from a planar shape of the first through electrode 1131. For example, referring to (c) of FIG. 24, the planar shapes of the second through electrode 1132 and the third through electrode 1133 may have triangular shapes different from a planar shape of the first through electrode 1131. That is, the second through electrode 1132 and the third through electrode 1133 may be filled in a through hole formed by an exposure and development process. In addition, formation of through holes having various planar shapes is possible through the exposure and development process. Accordingly, the second through electrode 1132 and the third through electrode 1133 may have the same planar shape as the first through electrode 1131, or may have different planar shapes from the first through electrode 1131.

The first protective layer 1141 and the second protective layer 1142 may be disposed on an outermost layer of the circuit board. For example, the first protective layer 1141 may be disposed at an uppermost side of the circuit board. For example, the first protective layer 1141 may be disposed on the second insulating layer 1112. For example, the second protective layer 1142 may be disposed at a lowermost side of the circuit board. Each surface of the first protective layer 1141 and the second protective layer 1142 may have a step. For example, a lower surface of the first protective layer 1141 may have a step. For example, an upper surface of the second protective layer 1142 may have a step. Specifically, the first protective layer 1141 may be disposed on the second insulating layer 1112. In addition, a lower surface of the first protective layer 1141 may include a portion positioned lower than an upper surface of the second insulating layer 1112. In addition, a lower surface of the first protective layer 1141 may include a portion positioned lower than upper and lower surfaces of the second circuit pattern layer 1122. For example, the first protective layer 1141 may include a portion positioned in an open region of the second insulating layer 1112. In addition, the first protective layer 1141 may be provided to fill the open region of the second insulating layer 1112. Therefore, at least a portion of the first protective layer 1141 may be in contact with the first insulating layer 1111. For example, the first protective layer 1141 may be positioned on the first insulating layer 1111 to cover the second insulating layer 1112. Specifically, the first protective layer 1141 may include an opening that vertically overlaps the cavity 1150. In addition, the first protective layer 1141 may include a portion that is in contact with an upper surface 1112US of the second insulating layer 1112. In addition, the first protective layer 1141 may include a portion that is in contact with an outer side surface 1120S of the second insulating layer 1112. In addition, the first protective layer 1141 may include a portion that is in contact with the upper surface 111US2 of the third region of the first insulating layer 1111. The outer side surface 1120S of the second insulating layer 1112 may not be exposed to the outside. That is, the outer side surface 1120S of the second insulating layer 1112 may not be exposed to the outside because the outer side surface 112OS of the second insulating layer 1112 is covered with the first protective layer 1141. Accordingly, the outer side surface of the circuit board of the embodiment may include a portion formed of the first insulating layer 1111 and a portion formed of the first protective layer 1141. In other words, the outer side surface of the circuit board of the embodiment may not include a portion formed of the second insulating layer 1112. Accordingly, the embodiment may have the first protective layer 1141 disposed on the first insulating layer 1111 to surround the second insulating layer 1112. Accordingly, the embodiment may solve a physical reliability problem and/or an electrical reliability problem in which the second insulating layer 1112 and/or the second circuit pattern layer 1122 are separated from the first insulating layer 1111. In addition, correspondingly, the second protective layer 1142 may be disposed under the third insulating layer 1113. In addition, the upper surface of the second protective layer 1142 may include a portion positioned higher than the lower surface of the third insulating layer 1113. In addition, the upper surface of the second protective layer 1142 may include a portion positioned higher than the upper and lower surfaces of the third circuit pattern layer 1123. For example, the second protective layer 1142 may include a portion positioned in an open region of the third insulating layer 1113. In addition, the second protective layer 1142 may be provided to fill the open region of the third insulating layer 1113. Therefore, at least a portion of the second protective layer 1142 may be in contact with the first insulating layer 1111. For example, the second protective layer 1142 may be positioned to cover the third insulating layer 1113 under the first insulating layer 1111. In addition, the second protective layer 1142 may include a portion in contact with the lower surface of the third insulating layer 1113, a portion in contact with the outer side surface 113OS of the third insulating layer 1113, and a portion in contact with the lower surface of the first insulating layer 1111. Accordingly, the outer side surface 113OS of the third insulating layer 1113 may not be exposed to the outside because it is covered with the second protective layer 1142. Accordingly, the outer side surface of the circuit board of the embodiment may include only a portion formed by the first insulating layer 1111, a portion formed by the first protective layer 1141, and a portion formed by the second protective layer 1142. In other words, the outer side surface of the circuit board of the embodiment may not include a portion formed by the second insulating layer 1112 and a portion formed by the third insulating layer 1113. Through this, the embodiment can be disposed so that the first protective layer 1141 and the second protective layer 1142 surround the second insulating layer 1112 and the third insulating layer 1113 on and/or below the first insulating layer 1111. Therefore, the embodiment can solve the physical reliability problem and/or the electrical reliability problem that the second insulating layer 1112, the second circuit pattern layer 1122, the third insulating layer 1113, and the third circuit pattern layer 1123 are separated from the first insulating layer 1111.

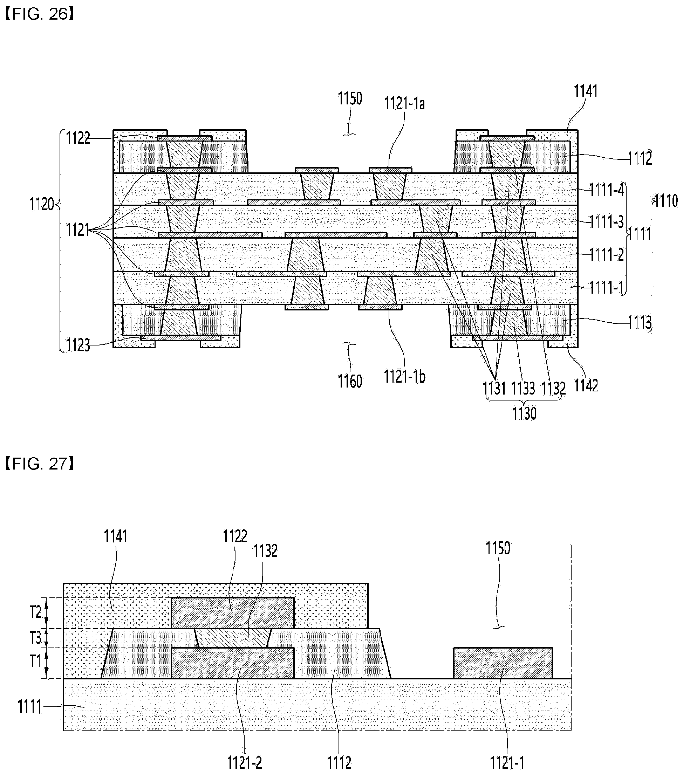

FIG. 26 is a cross-sectional view showing a circuit board according to a sixth embodiment.

Referring to FIG. 26, the circuit board of the sixth embodiment is similar in structure to the circuit board of the first embodiment of FIG. 21, and may differ from the structure of the circuit board of the first embodiment in that a cavity 1160 is provided in the third insulating layer 1113.

For example, a first cavity 1150 may be provided in the second insulating layer 1112. In addition, a second cavity 1160 may be provided in the third insulating layer 1113. Accordingly, the first circuit pattern layer 1121 may include a first electrode pad part 1121-1a disposed on the first insulating layer 1111 and exposed through the first cavity 1150.

In addition, the first circuit pattern layer 1121 may include a second electrode pad part 1121-1b disposed under the first insulating layer 1111 and exposed through the second cavity 1160.

FIG. 27 is a cross-sectional view showing a circuit board according to a seventh embodiment.

Referring to FIG. 27, the circuit board according to the seventh embodiment may have a different structure in terms of a thickness of the second insulating layer and a thickness of the through electrode passing through the second insulating layer compared to the circuit board of the fifth embodiment.

The second insulating layer 1112 may be disposed on the first insulating layer 1111 and may include an insulating material different from the first insulating layer 1111. At this time, an outer side surface of the second insulating layer 1112 and the outer side surface of the first insulating layer 1111 may have a step. In addition, the circuit board may have a symmetrical structure in which the second insulating layer 1112, which is an upper build-up layer, and the third insulating layer 1113, which is a lower build-up layer, are formed based on the first insulating layer 1111. Through this, the embodiment can prevent the circuit board from being greatly bent in a specific direction, and further, can secure adhesion between the second insulating layer 1112 and the first insulating layer 1111.

Therefore, the embodiment can drastically reduce a thickness of the second insulating layer 1112 compared to a conventional technology. For example, in the conventional technology, the second insulating layer 1112 had a thickness of a certain level or more in order to secure the warpage of the circuit board and adhesion between each layer of the circuit board. Therefore, in the conventional technology, the second through electrode 1132 passing through the second insulating layer 1112 had a thickness of a certain level or more. Specifically, the thickness of the second through electrode 1132 in the conventional technology is greater than the thickness of the first circuit pattern layer 1121 and/or the thickness of the second circuit pattern layer 1122.

In contrast, the embodiment can reduce the thickness of the second insulating layer 1112, thereby reducing the thickness of the second through electrode 1132 passing through the second insulating layer 1112. For example, a thickness T3 of the second through electrode 1132 of the embodiment can be made smaller than a thickness T1 of the first circuit pattern layer 1121 and/or a thickness T2 of the second circuit pattern layer 1122. Through this, the embodiment can reduce the thickness of the second through electrode 1132, and reduce a transmission distance of the signal passing through the second through electrode 1132. Therefore, the embodiment can minimize signal transmission loss, thereby improving product reliability. Furthermore, the embodiment may enable thinning of the circuit board and the semiconductor package.

In addition, a thickness T3 of the second through electrode 1132 may be smaller than the thickness of the first through electrode 1131 passing through the first insulating layer 1111. For example, the first insulating layer 1111 may be a thermosetting resin including glass fibers, or a thermosetting resin such as ABF that does not include glass fibers. In addition, the embodiment may reduce a thickness T3 of the second through electrode 1132 by structural features described above, and further reduce the ratio of the thickness T3 of the second through electrode 1132 to the thickness of the first through electrode 1131 to a range of more than 1:1.5 to less than 1.3.5. Through this, the embodiment may minimize signal transmission loss by reducing the signal transmission distance, and may enable thinning of the circuit board and the semiconductor package.

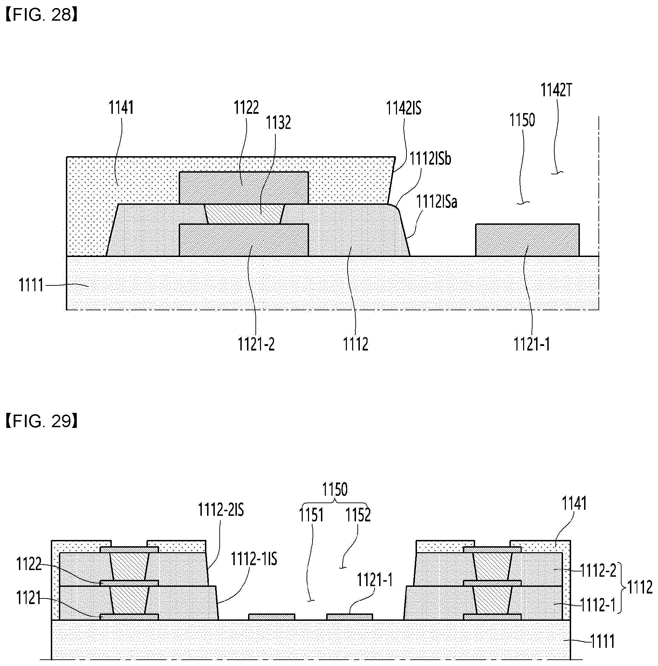

FIG. 28 is a cross-sectional view showing a circuit board according to an eighth embodiment.

Referring to FIG. 28, the circuit board according to the eighth embodiment may have different slopes of the inner wall of the opening of the first protective layer 1141 and the inner wall of the cavity 1150 compared to the circuit board of the seventh embodiment.

Briefly, referring to the fifth to seventh embodiments, the first protective layer 1141 has an opening that overlaps with the cavity 1150 in a vertical direction. At this time, a slope of the inner wall of the opening of the first protective layer 1141 may be different from a slope of the inner wall of the cavity 1150. For example, the slope of the inner wall of the opening of the first protective layer 1141 may be closer to 90 ° than the slope of the inner wall of the cavity 1150.

In contrast, an inner wall 1142IS forming the opening 1142T of the first protective layer 1141 of the eighth embodiment may have a slope in which the width of the opening 1142T changes from the upper surface of the first protective layer 1141 toward the lower surface of the first protective layer 1141. At this time, the inner wall 1142IS of the opening 1142T of the first protective layer 1141 may have a slope in which the width of the opening 1142T increases from the upper surface toward the lower surface of the first protective layer 1141. That is, the slope of the inner wall 1142IS of the opening 1142T of the first protective layer 1141 may be different from the slope of the inner wall 1121IS of the cavity 1150 of the second insulating layer 1112. A direction in which the slope of the inner wall 1142IS of the opening 1142T of the first protective layer 1141 is inclined may be different from a direction in which the slope of the inner wall 1121IS of the cavity 1150 of the second insulating layer 1112 is inclined. The direction in which the slope of the inner wall 1142IS of the opening 1142T of the first protective layer 1141 is inclined may be an opposite direction to the direction in which the slope of the inner wall 1121IS of the cavity 1150 of the second insulating layer 1112 is inclined. Accordingly, an contact area with the molding member (not shown) filling the cavity 1150 and the opening 1142T can be increased, and the mechanical reliability problem of the molding member being peeled off from the circuit board can be solved. For example, the slope of the inner wall 1142IS of the opening 1142T may be inclined in the opposite direction to the slope of the inner wall 1112IS of the cavity 1150, thereby functioning as an anchor to more firmly bond the molding member. Accordingly, the embodiment may enable the connection member to be stably positioned within the cavity 1150, thereby enabling the connection member to operate stably.

In addition, the slope of the inner wall 1112IS of the cavity 1150 of the second insulating layer 1112 may include a first portion 1112ISa having a straight slope that is connected to the lower surface of the second insulating layer 1112 and/or the lower surface of the cavity 1150, and the width of the cavity 1150 gradually increases as it approaches the upper surface of the second insulating layer 1112. In addition, the slope of the inner wall 1112IS of the cavity 1150 of the second insulating layer 1112 may include a second portion 1112ISb having a curved slope that is connected to the upper surface of the second insulating layer 1112 and/or the inner wall 1142IS of the opening 1142T of the first protective layer 1141 and the width of the cavity 1150 decreases as it goes toward the lower surface of the second insulating layer 1112. At this time, the second portion 11121Sb of the inner wall 1112IS of the cavity 1150 of the second insulating layer 1112 may improve the processability in a process of filling the molding member. For example, the second portion 1112ISb of the inner wall 1112IS of the cavity 1150 of the second insulating layer 1112 improves the flowability of the molding liquid so that the molding liquid can flow more easily into the cavity 1150, thereby preventing voids that are not filled with the molding liquid from being formed in the cavity 1150.

FIG. 29 is a cross-sectional view showing a circuit board according to the ninth embodiment.

Referring to FIG. 29, the circuit board of the ninth embodiment may be different from the circuit board of the fifth embodiment in the number of layers of the second insulating layer and the structure of the cavity according to the second insulating layer.

For example, the second insulating layer 1112 may be formed in multiple layers. For example, the second insulating layer 1112 may include a first layer 1112-1 disposed on the first insulating layer 1111 and a second layer 1112-2 disposed on the first layer 1112-1. In addition, the second insulating layer 1112 may be provided with a cavity 1150. The cavity 1150 may pass through the second insulating layer 1112. For example, the cavity 1150 may include a first part 1151 passing through the first layer 1112-1 of the second insulating layer 1112 and a second part 1152 passing through the second layer 1112-2 of the second insulating layer 1112. For example, when the second insulating layer 1112 includes a plurality of layers, the cavity 1150 can pass through the plurality of layers of the second insulating layer 1112. At this time, the first part 1151 and the second part 1152 of the cavity 1150 can be formed in separate processes. For example, the first part 1151 of the cavity 1150 can be formed together with the first through hole in a process of forming the first through hole in the first layer 1112-1 of the second insulating layer 1112. In addition, the second part 1152 of the cavity 1150 can be formed together with the second through hole in a process of forming the second through hole in the second layer 1112-2 of the second insulating layer 1112. Accordingly, the first part 1151 and the second part 1152 of the cavity 1150 may have different widths. For example, the cavity 11150 may include a plurality of side walls. For example, the cavity 1150 may include a first side wall 112-1IS corresponding to the first part 1151. In addition, the cavity 1150 may include a second side wall 1112-2IS corresponding to the second part 1152. In addition, the first side wall 1112IS and the second side wall 1112-2IS may have a step. For example, a width of the first part 1151 and a width of the second part 1152 may be different from each other.

Accordingly, the side wall of the cavity 1150 of the embodiment may have a step shape. By this, the embodiment can increase a contact area with the molding member filling the cavity 1150. Therefore, the embodiment can improve the adhesion between the molding member and the circuit board, thereby solving the physical reliability problem of the molding member being separated from the circuit board.

The outer side surface of the first layer 1112-1 of the second insulating layer 1112 and the outer side surface of the second layer 1112-2 can also have a step from each other. Accordingly, the embodiment can improve the contact area between the first protective layer 1141 and the first layer 1112-1 and the second layer 1112-2 of the second insulating layer 1112. Accordingly, the embodiment can solve the physical reliability problem of the second insulating layer 1112 being separated from the first insulating layer 1111. At this time, a structure of the third insulating layer 1113 may correspond to the structure of the second insulating layer 1112 described in FIG. 27.

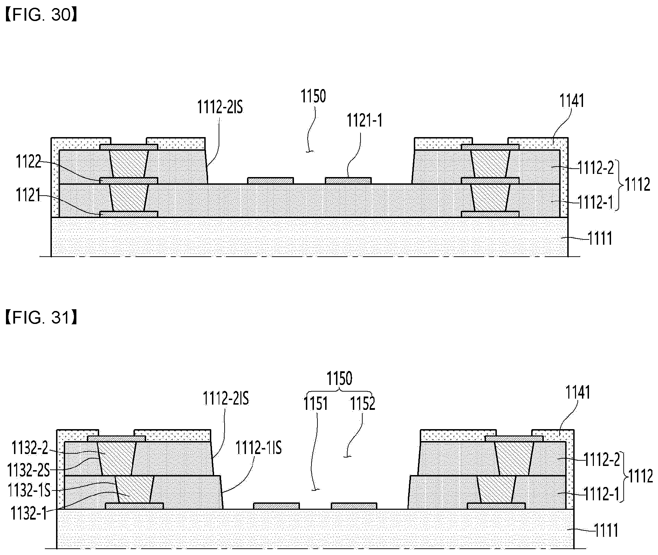

FIG. 30 is a cross-sectional view showing a circuit board according to a tenth embodiment.

Referring to FIG. 30, the circuit board of the tenth embodiment may be different from the circuit board of the ninth embodiment in a structure of the cavity.

The second insulating layer 1112 may be provided in multiple layers. For example, the second insulating layer 1112 may include a first layer 1112-1 disposed on the first insulating layer 1111 and a second layer 1112-2 disposed on the first layer 1112-1. The cavity 1150 may be optionally provided in the second layer 1112-2 of the second insulating layer 1112. For example, the cavity 1150 may pass through the second layer 1112-2 of the second insulating layer 1112. That is, the cavity 1150 provided in the circuit board of the tenth embodiment may pass through some of the layers of the second insulating layer 1112. Therefore, an insulating layer forming the lower surface of the cavity 1150 may be some layers of the second insulating layer 1112 that do not include glass fibers. Therefore, the embodiment may prevent the glass fibers from being exposed even if a de-smear process is performed after the cavity 1150 is formed.

FIG. 31 is a cross-sectional view illustrating a circuit board according to an eleventh embodiment.

Referring to FIG. 31, the circuit board of the eleventh embodiment may be different from the circuit board of the ninth embodiment in the structure of the second through electrode.

The second insulating layer 1112 may include a first layer 1112-1 and a second layer 1112-1. In addition, a first through part 1132-1 of a second through electrode may be disposed in the first layer 1112-1 of the second insulating layer 1112. In addition, a second through part 1132-2 of a second through electrode may be disposed in the second layer 1112-2 of the second insulating layer 1112.

At this time, the first through part 1132-1 and the second through part 1132-2 of the second through electrode may be provided by filling the inside of the through hole formed by exposing and developing the first layer 1112-1 and the second layer 1112-1 of the second insulating layer 1112 with a conductive material, respectively. At this time, an upper surface of the first through part 1132-1 may be in direct contact with a lower surface of the second through part 1132-2. For example, a pad corresponding to a land of the through electrode may not be provided between the first through part 1132-1 and the second through part 1132-2. For example, when the through hole is formed by a laser process, a pad corresponding to a land that acts as a stopper in a laser process must be provided between the first through part 1132-1 and the second through part 1132-2. In contrast, the embodiment can form a through hole using an exposure and development process instead of a laser process, thereby omitting a pad corresponding to a land. Accordingly, the embodiment can simplify the manufacturing process by omitting a pad that must be provided between the first through part 1132-1 and the second through part 1132-2, thereby improving the product yield.

That is, the first through part 1132-1 has an upper surface, a lower surface, and a side surface 1132-1S. The side surface 1132-1S of the first through part 1132-1 described above can have a slope whose width gradually decreases toward the upper surface and the lower surface of the first through part 1132-1. The side surface 1132-1S of the first through part 1132-1 can connect the upper surface and the lower surface of the first through part 1132-1. The second through part 1132-2 has an upper surface, a lower surface, and a side surface 1132-2S. The side surface 1132-2S of the second through part 1132-2 described above may have a slope whose width gradually decreases toward the upper surface and the lower surface of the second through part 1132-2. The side surface 1132-2S of the second through part 1132-2 may connect the upper surface and the lower surface of the second through part 1132-2.

At this time, the side surface 1132-1S of the first through part 1132-1 and the side surface 1132-2S of the second through part 1132-2 may have a step along the vertical direction. For example, a center of the first through part 1132-1 in a horizontal direction may be misaligned with a center of the second through part 1132-2 in a horizontal direction. Accordingly, the embodiment can omit the pad that should be provided between the first through part 1132-1 and the second through part 1132-2 while making the centers of each of them misaligned. Accordingly, the embodiment can avoid affecting the mechanical reliability and/or electrical reliability of the circuit board even if the positions of the first through part 1132-1 and the second through part 1132-2 are not precisely aligned, thereby improving the mechanical reliability and/or electrical reliability of the circuit board while enhancing the design freedom of the first through part 1132-1 and the second through part 1132-2.

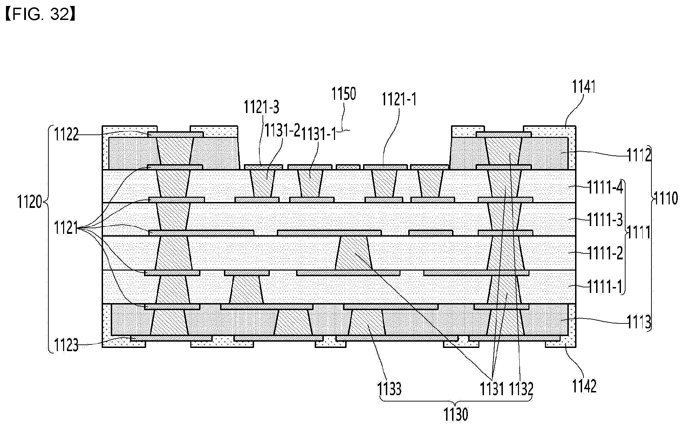

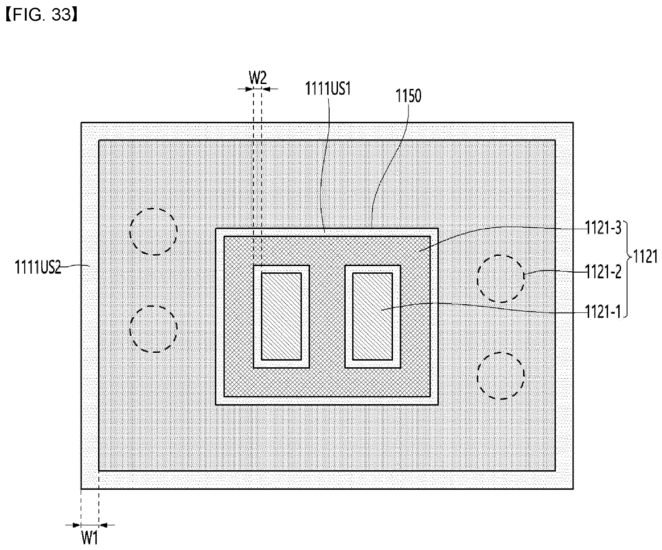

FIG. 32 is a cross-sectional view illustrating a circuit board according to a twelfth embodiment, and FIG. 33 a plan view in which some components are omitted from the circuit board of FIG. 32.

Referring to FIGS. 32 and 33, the circuit board of the eighth embodiment may differ from the circuit board of the fifth embodiment in a structure of the first circuit pattern layer 1121 exposed through the cavity 1150 of the second insulating layer 1112 and a structure of the first through electrode 1131.

The first circuit pattern layer 1121 may include a first electrode pad 1121-1 disposed on the first insulating layer 1111 and vertically overlapping the cavity 1150. In addition, the first circuit pattern layer 1121 may include a second electrode pad 1121-2 disposed on the first insulating layer 1111 and not vertically overlapping the cavity 1150. In addition, the first circuit pattern layer 1121 may further include a dummy electrode 1121-3 disposed on the first insulating layer 1111 and at least partially vertically overlapping the cavity 1150. The dummy electrode 1121-3 may be disposed in a region of the first region of the first insulating layer 1111 vertically overlapping the cavity 1150 where the first electrode pad 1121-1 is not disposed. For example, the circuit board may further include a dummy electrode 1121-3 spaced apart from the first electrode pad 1121-1 on the first region of the first insulating layer 1111. The dummy electrode 1121-3 may function to protect a portion of the upper surface 1111US1 of the first region of the first insulating layer 1111 where the first electrode pad 1121-1 is not disposed. For example, the dummy electrode 1121-3 may be referred to as a protective pattern or barrier pattern that protects the upper surface 1111US1 of the first region of the first insulating layer 1111. Therefore, the dummy electrode 1121-3 can prevent the etching of the upper surface 1111US1 of the first region of the first insulating layer 1111 during the de-smear process. Through this, the embodiment can prevent reliability problems such as copper migration caused by the etching of the upper surface 1111US1 of the first region of the first insulating layer 1111. Therefore, the embodiment can improve the electrical reliability of the circuit board.

The dummy electrode 1121-3 can be spaced apart from the first electrode pad 1121-1 on the upper surface 1111US1 of the first region. The dummy electrode 1121-3 can be spaced apart from the first electrode pad 1121-1 by a first width W2. The first width W2 can satisfy a range of 10 µm to 30 µm. Since this has been described with reference to FIGS. 2 to 13, a detailed description thereof will be omitted.

A first through electrode 1131 can be disposed on the first insulating layer 1111. At this time, the first through electrode 1131 can include a plurality of through parts. For example, the first through electrode 1131 can include a first through part 1131-1 that vertically overlaps the first electrode pad 1121-1. The first through part 1131-1 can be a signal through electrode that is electrically connected to the first electrode pad 1121-1.

In addition, the first through electrode 1131 may include a second through part 1131-2 that is vertically overlapped with the first region and horizontally spaced from the first through part 1131-1. The second through part 1131-2 may be vertically overlapped with the dummy electrode 1121-3. For example, the second through part 1131-2 may be a dummy through electrode connected to the dummy electrode 1121-3. At this time, the second through part 1131-2 may be provided in multiple numbers. For example, the second through part 1131-2 may include a plurality of through parts that are horizontally spaced and commonly connected to one dummy electrode 1121-3.

At this time, the dummy electrode 1121-3 and the second through part 1131-2 may have a function of improving the heat dissipation characteristics of the circuit board. For example, the dummy electrode 1121-3 and the second through part 1131-2 can transfer heat generated from a connection member disposed in a cavity 1150 to the outside of the circuit board. Through this, the embodiment can improve the heat dissipation characteristics of the circuit board and the semiconductor package including the same. Therefore, the embodiment can improve the product reliability of the circuit board and the semiconductor package including the same.

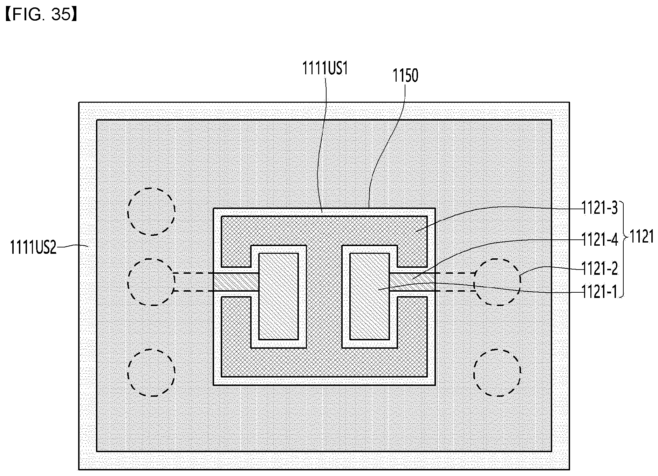

FIG. 34 is a cross-sectional view illustrating a circuit board according to a thirteenth embodiment, and FIG. 35 is a plan view in which some components are omitted from the circuit board of FIG. 21

Referring to FIGS. 34 and 35, a first circuit pattern layer 1121 of a circuit board of the thirteenth embodiment may include a first electrode pad 1121-1 disposed on a first region. In addition, the first circuit pattern layer 1121 may include a second electrode pad 1121-2 disposed on a second region. In addition, the first circuit pattern layer 1121 may include a dummy electrode 1121-3 disposed on the first region and electrically and physically separated from the first electrode pad 1121-1. The first electrode pad 1121-1 and the second electrode pad 1121-2 may directly exchange electrical signals with each other on the first insulating layer 1111 without being connected to the first through electrode 1131. To this end, the first circuit pattern layer 1121 may include a connection pattern 1121-4. The connection pattern 1121-4 may be disposed on the first region and the second region of the first insulating layer 1111. At this time, the first circuit pattern layer 1121 may include a plurality of connection patterns, and the connection pattern 1121-4 described below may mean a connection pattern that connects the first electrode pad 1121-1 and the second electrode pad 1121-2 among the plurality of connection patterns. The connection pattern 1121-4 may directly connect the first electrode pad 1121-1 disposed on the first region and the second electrode pad 1121-2 disposed on the second region. Through this, the embodiment may reduce the signal transmission distance between the first electrode pad 1121-1 and the second electrode pad 1121-2. Therefore, the embodiment may minimize signal transmission loss, and further improve the electrical characteristics of the circuit board and the semiconductor package including the same. The connection pattern 1121-4 may include a first portion disposed on a first region and connected to the first electrode pad 1121-1. In addition, the connection pattern 1121-4 may include a second portion disposed on a second region and connected to the second electrode pad 1121-2. In addition, the first and second portions of the connection pattern 1121-4 may be directly connected to each other. Accordingly, the first electrode pad 1121-1 and the second electrode pad 1121-2 may directly exchange electrical signals with each other using the connection pattern 1121-4 without passing through the first through electrode 1131. Through this, the embodiment may improve the circuit integration of the circuit board by arranging the connection pattern 1121-4 on the first region of the first insulating layer 1111.

The connection pattern 1121-4 can be physically separated from the dummy electrode 1121-3 while making contact with the first electrode pad 1121-1 in the first region. Furthermore, the first circuit pattern part, which occupies a range of 50% to 90%, a range of 55% to 85%, or a range of 60% to 85% of the total area of the upper surface 1111US1 of the first region, includes the first electrode pad 1121-1 and the dummy electrode 1121-3. In addition, the first circuit pattern part, which occupies a range of 50% to 90%, a range of 55% to 85%, or a range of 60% to 85% of the total area of the first region, can include the first electrode pad 1121-1, the dummy electrode 1121-3, and the connection pattern 1121-4.

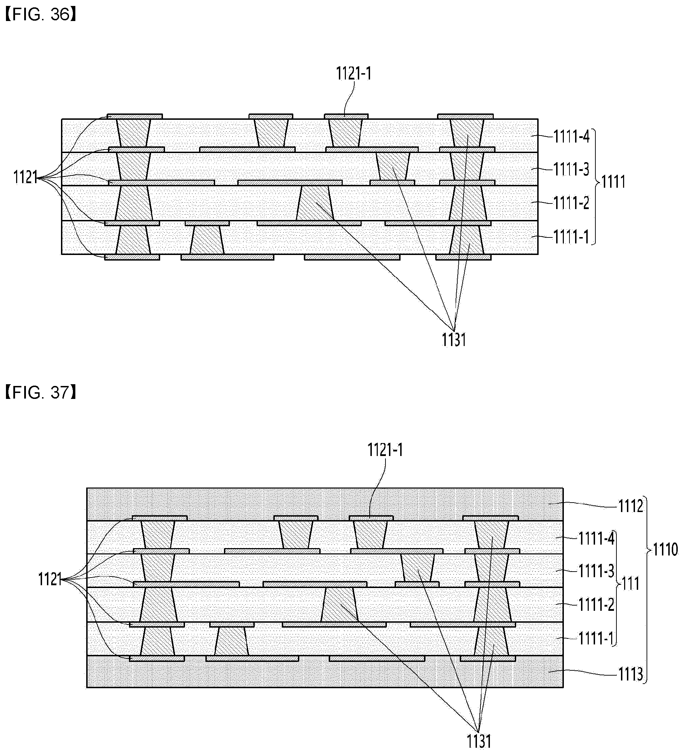

FIGS. 36 to 41 are views showing a method of manufacturing the circuit board of FIG. 21 in order of processes.

Referring to FIG. 36, the embodiment may proceed with a process of manufacturing an inner layer of the circuit board. Here, the inner layer of the circuit board may include a first insulating layer 1111, a first through electrode 1131, and a first circuit pattern layer 1121.

Next, referring to FIG. 37, the embodiment may place a second insulating layer 1112 on the first insulating layer 1111. In addition, the embodiment may place a third insulating layer 1113 under the first insulating layer 1111. At this time, the second insulating layer 1112 and the third insulating layer 1113 may include an insulating material different from the first insulating layer 1111. For example, the second insulating layer 1112 and the third insulating layer 1113 may include a photocurable resin.

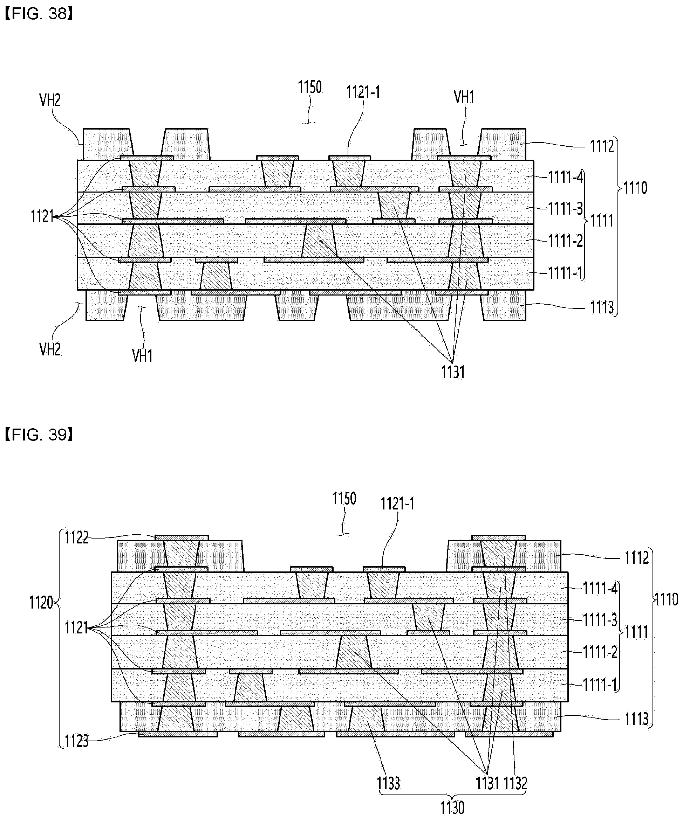

Next, referring to FIG. 38, the embodiment may perform a process of exposing and developing the second insulating layer 1112 and the third insulating layer 1113, respectively. For example, the embodiment may perform a process of exposing and developing the second insulating layer 1112 to form a first through hole VH1, a second through hole VH2, and a cavity 1150. The first through hole VH1 of the second insulating layer 1112 may be provided corresponding to a region where the second through electrode 1132 is to be disposed. In addition, the second through hole VH2 of the second insulating layer 1112 may pass through an edge region of the second insulating layer 1112. Through this, an upper surface of the edge region of the first insulating layer 1111 can be exposed through the second through hole VH2 of the second insulating layer 1112. In addition, the third insulating layer 1113 can also be provided with the first through hole VH1 and the second through hole VH2 correspondingly.

Next, referring to FIG. 39, the embodiment can perform a process of forming the second circuit pattern layer 1122, the second through electrode 1132, the third circuit pattern layer 1123, and the third through electrode 1133.

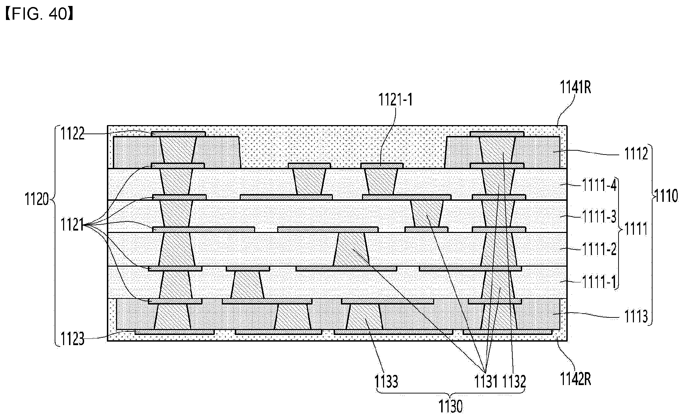

Next, referring to FIG. 40, the embodiment can perform a process of forming a first resist layer 1141R on the second insulating layer 1112. The first resist layer 1141R may be provided to fill the second through hole VH2 and the cavity 1150 of the second insulating layer 1112. In addition, the embodiment may perform a process of forming a second resist layer 1142R under the third insulating layer 1113. In addition,, the second resist layer 1142R may be provided to fill the second through hole VH2 of the third insulating layer 1113.

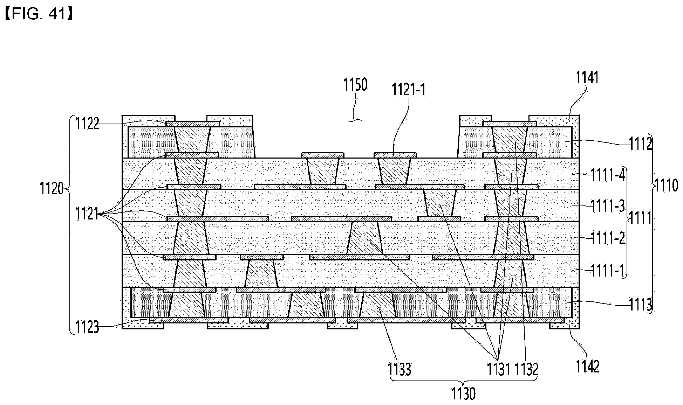

Thereafter, referring to FIG. 41, the embodiment may perform a process of forming the first protective layer 1141 by forming an opening vertically overlapped with the cavity 1150 and an opening vertically overlapped with the second circuit pattern layer 1122 in the first resist layer 1141R. In addition, the embodiment can proceed with a process of forming a second protective layer 1142 by forming an opening vertically overlapped with the third circuit pattern layer 1123 in the second resist layer 1142R.

On the other hand, when the circuit board having the above-described characteristics of the invention is used in an IT device or home appliance such as a smart phone, a server computer, a TV, and the like, functions such as signal transmission or power supply can be stably performed. For example, if a circuit board having the features of the present invention performs a semiconductor package function, the circuit board can function to safely protect the semiconductor device from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor device. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
a first insulating layer;
a second insulating layer disposed on the first insulating layer; and
a circuit pattern layer disposed between the first insulating layer and the second insulating layer,
wherein the second insulating layer includes a cavity passing through upper and lower surfaces of the second insulating layer, and
wherein the circuit pattern layer includes:
an electrode pad disposed on a lower surface of the cavity; and
a dummy electrode disposed on the lower surface of the cavity and spaced apart from the electrode pad and surrounding an outer side of the electrode pad.

2. The circuit board of claim 1, wherein an outer side surface of the first insulating layer has a step with respect to an outer side surface of the second insulating layer.

3. The circuit board of claim 2, wherein the first insulating layer and the second insulating layer include different insulating materials.

4. The circuit board of claim 3, wherein the second insulating layer includes a photocurable resin.

5. The circuit board of claim 4, wherein the outer side surface of the second insulating layer is provided further inward than the outer side surface of the first insulating layer.

6. The circuit board of claim 2, further comprising:
a protective layer disposed on the second insulating layer, and
wherein an outer side surface of the protective layer has a step with respect to the outer side surface of the second insulating layer.

7. The circuit board of claim 6, wherein the protective layer is provided to cover the outer side surface of the second insulating layer.

8. The circuit board of claim 2, wherein the outer side surface of the second insulating layer has a slope in which an outer width of the second insulating layer decreases or increases from the upper surface of the second insulating layer toward the lower surface of the second insulating layer.

9. The circuit board of claim 6, wherein the protective layer includes an opening overlapping the cavity in a vertical direction, and
wherein a slope of an inner wall of the opening is different from a slope of an inner wall of the cavity.

10. The circuit board of claim 9, wherein a direction in which the slope of the inner wall of the opening is inclined is different from a direction in which the slope of the inner wall of the cavity is inclined.
